# EUROPEAN PATENT APPLICATION

(11) **EP 4 712 746 A1**
(43) Date of publication of application: **18.03.2026**
(21) Application number: 25201577.1
(22) Date of filing: 11.09.2025
(51) Int. Cl.: H10K 59/121, H10K 59/131

(54) **DISPLAY APPARATUS AND ELECTRONIC APPARATUS INCLUDING THE SAME**

(30) Priority: 12.09.2024 KR 20240124836
(71) Applicant: Samsung Display Co., Ltd., Yongin-si, Gyeonggi-do 17113 (KR)
(72) Inventor: Cha, Nahyeon, 17113 Yongin-si, Gyeonggi-do (KR); Park, Junhyun, 17113 Yongin-si, Gyeonggi-do (KR); Son, Sunkwun, 17113 Yongin-si, Gyeonggi-do (KR); Lee, Cheol-Gon, 17113 Yongin-si, Gyeonggi-do (KR)
(74) Representative: Gulde & Partner

(57) **Abstract**

Provided is a display apparatus including a first pixel and a second pixel disposed adjacent to each other in a first direction, first electrodes disposed in each of the first pixel and the second pixel, and second electrodes disposed in each of the first pixel and the second pixel and apart from the first electrodes. The first electrodes are symmetrically disposed with respect to an imaginary line disposed at a boundary between the first pixel and the second pixel and extending in a second direction that is different from the first direction. The second electrodes are asymmetrically disposed with respect to the imaginary line.

## Description

### BACKGROUND

### 1. TECHNICAL FIELD

One or more embodiments relate to a display apparatus.

### 2. DESCRIPTION OF THE RELATED ART

Among display apparatuses, organic light-emitting display apparatuses are attracting attention as next-generation displays because the organic light-emitting display apparatuses have the advantages of wide viewing angles, excellent contrast, and fast response times.

In general, organic light-emitting display apparatuses, thin-film transistors and organic light-emitting diodes acting as display elements are formed on a substrate. The organic light-emitting diodes are operated to emit light by themselves. Organic light-emitting display apparatuses may be used as displays for small products such as mobile phones or large products such as televisions.

### SUMMARY

One or more embodiments provide a display apparatus having a structure that is robust even against an overlay deviation.

Additional aspects will be set forth in part in the description which follows and, in part, will be apparent from the description, or may be learned by practice of the presented embodiments of the disclosure.

According to one or more embodiments, a display apparatus includes a first pixel and a second pixel disposed adjacent to each other in a first direction, first electrodes disposed in each of the first pixel and the second pixel and second electrodes disposed in each of the first pixel and the second pixel and adjacent to a source node of each of the first pixel and the second pixel and apart from the first electrodes, wherein the first electrodes are symmetrically disposed with respect to an imaginary line disposed at a boundary between the first pixel and the second pixel and extending in a second direction that is different from the first direction, and the second electrodes are asymmetrically disposed with respect to the imaginary line.

In an embodiment, the display apparatus may further include a data line disposed at the boundary between the first pixel and the second pixel, extending in the second direction, and disposed along the imaginary line.

In an embodiment, the first electrodes, the second electrodes, and the data line may include a same conductive material.

In an embodiment, one of the first electrodes may be a first capacitor electrode.

In an embodiment, the first capacitor electrode may have a symmetrical structure with respect to the second direction.

In an embodiment, the display apparatus may further include a first scan signal line extending in the first direction, crossing the first pixel and the second pixel, and electrically connected to one of the second electrodes, wherein at least one of the second electrodes may be disposed between the first scan signal line and the first capacitor electrode.

In an embodiment, the first scan signal line may include a first-1 scan signal line and a first-2 scan signal line parallel to the first-1 scan signal line, extending in the first direction.

In an embodiment, the display apparatus may further include a lower capacitor electrode overlapping the first capacitor electrode, wherein the lower capacitor electrode and the first scan signal line may include a same material.

In an embodiment, the lower capacitor electrode disposed in the first pixel and the lower capacitor electrode disposed in the second pixel may be symmetrically disposed with respect to the imaginary line.

In an embodiment, the lower capacitor electrode may have a symmetrical structure with respect to the second direction.

In an embodiment, the display apparatus may further include an initialization voltage line extending in the first direction and crossing the first pixel and the second pixel, wherein at least one of the first electrodes may be disposed between the first capacitor electrode and the initialization voltage line.

In an embodiment, the display apparatus may further include a first capacitor disposed in each of the first pixel and the second pixel, wherein the first capacitor may include the first capacitor electrode and a second capacitor electrode overlapping the first capacitor electrode.

In an embodiment, the display apparatus may further include a second capacitor disposed in each of the first pixel and the second pixel, wherein the second capacitor may include a third capacitor electrode and a fourth capacitor electrode overlapping the third capacitor electrode, and the fourth capacitor electrode may be integrally formed with the first capacitor electrode.

According to one or more embodiments, a display apparatus includes a first pixel and a second pixel disposed adjacent to each other in a first direction, a driving transistor disposed in each of the first pixel and the second pixel, the driving transistor including a driving gate electrode, and a switching transistor disposed in each of the first pixel and the second pixel and electrically connected to the driving transistor, the switching transistor including a switching gate electrode, wherein the driving gate electrode of the first pixel and the driving gate electrode of the second pixel are symmetrically disposed with respect to an imaginary line disposed at a boundary between the first pixel and the second pixel and extending in a second direction that is different from the first direction, and the switching gate electrode of the first pixel and the switching gate electrode of the second pixel are asymmetrically disposed with respect to the imaginary line.

In an embodiment, the display apparatus may further include a first electrode disposed in each of the first pixel and the second pixel and overlapping the driving gate electrode, wherein the first electrode of the first pixel and the first electrode of the second pixel may be symmetrically disposed with respect to the imaginary line.

In an embodiment, the first electrode may have a symmetrical structure with respect to the second direction.

In an embodiment, the driving transistor may include a driving semiconductor layer, the switching transistor may include a switching semiconductor layer, and each of the driving semiconductor layer and the switching semiconductor layer may include an oxide semiconductor material.

In an embodiment, the driving transistor may include a driving semiconductor layer, the switching transistor may include a switching semiconductor layer, and each of the driving semiconductor layer and the switching semiconductor layer may include an n-type semiconductor.

In an embodiment, the display apparatus may further include an operation control transistor disposed in each of the first pixel and the second pixel and electrically connected to the driving transistor, the operation control transistor including an operation control gate electrode, wherein the operation control gate electrode of the first pixel and the operation control gate electrode of the second pixel may be symmetrically disposed with respect to the imaginary line.

According to one or more embodiments, an electronic apparatus includes a display apparatus and wherein the display apparatus including a first pixel and a second pixel disposed adjacent to each other in a first direction; first electrodes disposed in each of the first pixel and the second pixel; and second electrodes disposed in each of the first pixel and the second pixel and apart from the first electrodes, the first electrodes are symmetrically disposed with respect to an imaginary line disposed at a boundary between the first pixel and the second pixel and extending in a second direction that is different from the first direction, and the second electrodes are asymmetrically disposed with respect to the imaginary line.

Other aspects, features, and advantages of the disclosure will become better understood through the detailed description, the claims, and the accompanying drawings.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a schematic plan view of a display apparatus according to an embodiment;
FIG. 2 is a schematic diagram illustrating wirings included in a display apparatus according to an embodiment;
FIG. 3 is a schematic diagram of an equivalent circuit of a pixel according to an embodiment;
FIG. 4 is a schematic layout diagram illustrating a portion of an area including a first pixel and a second pixel in a display area of the display apparatus of FIG. 1;
FIG. 5 is a schematic layout diagram illustrating positions of thin-film transistors in the first pixel;
FIG. 6 is a schematic cross-sectional view schematically illustrating the display apparatus of FIG. 4 taken along line I-I' of FIG. 4;
FIGS. 7 to 11 are schematic layout diagrams illustrating components of the display apparatus illustrated in FIG. 4, including thin-film transistors, a storage capacitor, and a holding capacitor, on a layer basis;
FIG. 12 is a schematic layout diagram illustrating a portion of an area including a first pixel and a second pixel in a display area of a display apparatus according to another embodiment;
FIGS. 13 and 14 are schematic layout diagrams illustrating components of the display apparatus illustrated in FIG. 12, including thin-film transistors, a storage capacitor, and a holding capacitor, on a layer basis;
FIGS. 15 and 16 are schematic layout diagrams illustrating a portion of an area including a first pixel and a second pixel in a display area of a display apparatus according to another embodiment;
FIG. 17 is a schematic block diagram illustrating a display system according to an embodiment; and
FIG. 18 is a schematic view showing an example of a smart watch including a display apparatus according to an embodiment.

### DETAILED DESCRIPTION OF THE EMBODIMENTS

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," in case that preceding a list of elements, modify the entire list of elements and do not modify the individual elements of the list.

As the present description allows for various changes and numerous embodiments, certain embodiments will be illustrated in the drawings and described in detail in the written description. Effects and features of the disclosure, and methods of achieving them will be clarified with reference to embodiments described below in detail with reference to the drawings. However, the disclosure is not limited to the following embodiments and may be embodied in various forms.

In the following embodiments, the terms "first," "second," etc. are not used in a restrictive sense and are used to distinguish one element from another.

The singular forms as used herein are intended to include the plural forms as well unless the context clearly indicates otherwise.

It will be further understood that the terms "include" and/or "comprise" used herein specify the presence of stated features or elements, but do not preclude the presence or addition of one or more other features or elements.

In the following embodiments, it will be understood that, in case that a portion such as unit, region, or element is referred to as being "on" another portion, this may include not only a case where the portion is directly on another portion, but also a case where intervening units, regions, or elements may be present therebetween.

In the following embodiments, it will be understood that the terms "connection" or "coupling" do not necessarily mean "direct and/or fixed connection or coupling" of two members, unless the context clearly indicates otherwise, and this does not preclude the disposition of other members between the two members.

Also, sizes of elements in the drawings may be exaggerated or reduced for convenience of explanation. For example, because sizes and/or thicknesses of elements in the drawings are arbitrarily illustrated for convenience of explanation, the disclosure is not limited thereto.

Hereinafter, embodiments will be described in detail with reference to the accompanying drawings. In case that describing embodiments with reference to the accompanying drawings, the same or corresponding elements are denoted by the same reference numerals, and redundant descriptions thereof are omitted.

It will be understood that, in case that a layer, film, region, or plate is referred to as being "on" another element, the layer, film, region, or plate may be "directly on" another element, and intervening elements may be present therebetween. Also, sizes of elements in the drawings may be exaggerated or reduced for convenience of explanation. For example, because sizes and thicknesses of elements in the drawings are arbitrarily illustrated for convenience of explanation, the disclosure is not necessarily limited thereto.

Hereinafter, embodiments will be described with reference to the accompanying drawings.

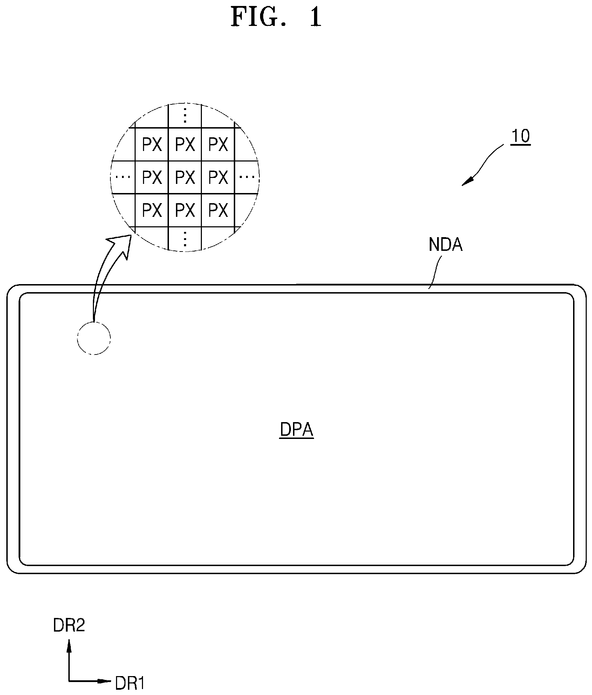

FIG. 1 is a schematic plan view of a display apparatus 10 according to an embodiment.

Referring to FIG. 1, the display apparatus 10 may be applied to various electronic devices, for example, tablet personal computers (PCs), smartphones, car navigation units, cameras, center information displays (CIDs) provided in cars, wristwatch-type electronic devices, personal digital assistants (PDAs), portable multimedia players (PMPs), small- and medium-sized electronic devices such as game consoles, televisions, outdoor billboards, monitors, PCs, and laptop computers. However, such electronic devices are merely example embodiments, and it is obvious that the display apparatus 10 may be applied to other electronic devices without departing from the concept of the disclosure.

The display apparatus 10 may include a display panel that provides a display screen. Examples of the display panel may include an inorganic light-emitting diode display panel, an organic light-emitting display panel, a quantum dot light-emitting display panel, a plasma display panel, and a field emission display panel. A case where an inorganic light-emitting diode display panel is applied is described as an example of the display panel, but the disclosure is not limited thereto, and other display panels may also be applied as long as the same technical concept is applicable.

The shape of the display apparatus 10 may be variously modified. For example, the display apparatus 10 may have a rectangular shape with a long width, a rectangular shape with a long height, a square shape, a rectangular shape with round corners (vertices), other polygonal shapes, a circular shape, etc. The shape of a display area DPA in the display apparatus 10 may also be similar to the overall shape of the display apparatus 10. FIG. 1 illustrates the display apparatus 10 and the display area DPA each having a rectangular shape with a long width.

The display apparatus 10 may include two first sides extending in one direction and two second sides extending in another direction crossing the one direction. A corner at which the first side and the second side of the display apparatus 10 meet may be a right angle, but the disclosure is not limited thereto, and the corner may also be curved. In some embodiments, the first side may be shorter than the second side, but the disclosure is not limited thereto. The planar shape of the display apparatus 10 is not limited to the examples described above, and the display apparatus 10 may have a circular shape or other shapes.

The display apparatus 10 may include the display area DPA and a non-display area NDA. The display area DPA is an area where a screen is displayed and the non-display area NDA is an area where a screen is not displayed. The display area DPA may also be referred to as an active area and the non-display area NDA may also be referred to as an inactive area. The display area DPA may occupy approximately the center of the display apparatus 10.

The display area DPA may include multiple pixels PX. Multiple pixels PX may be disposed in row and column directions. In a plan view, the pixels PX may each have a rectangular shape or a square shape, but the disclosure is not limited thereto, and the pixels PX may each have a rhombus shape with each side tilted in one direction. The pixels PX may be alternately disposed in a stripe type or a pentile type. The pixels PX may each include one or more light-emitting elements to emit light of a specific wavelength to display a specific color.

The non-display area NDA may be disposed around the display area DPA. The non-display area NDA may completely or partially surround the display area DPA. The display area DPA may have a rectangular shape and the non-display areas NDA may be disposed adjacent to four sides of the display area DPA. The non-display areas NDA may constitute a bezel of the display apparatus 10. Wirings or circuit drivers included in the display apparatus 10 may be disposed in the non-display areas NDA, or external devices may be mounted in the non-display areas NDA.

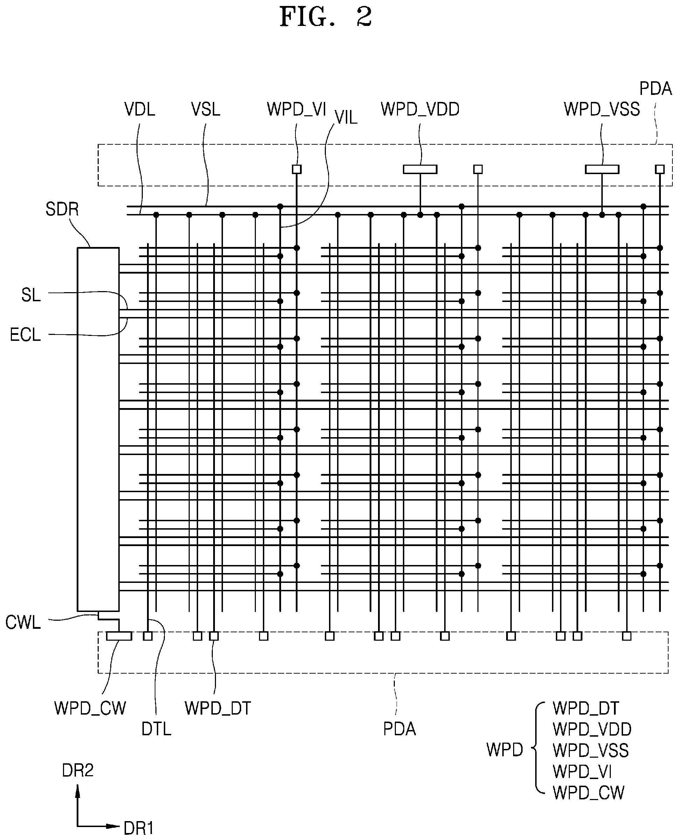

FIG. 2 is a schematic diagram illustrating wirings included in the display apparatus 10 according to an embodiment.

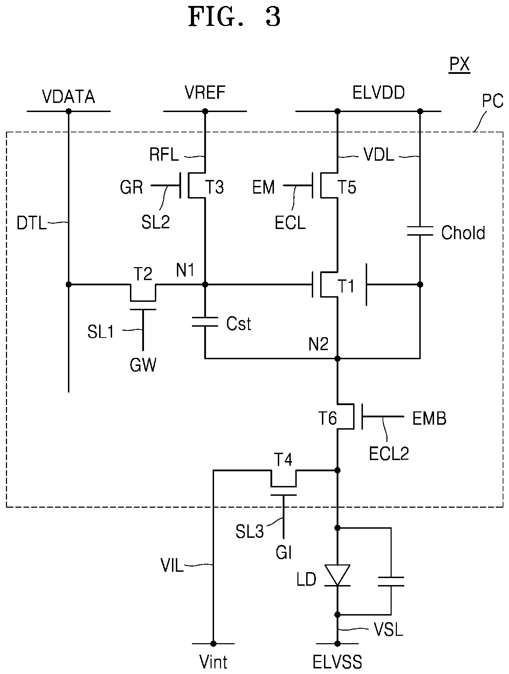

Referring to FIG. 2, the display apparatus 10 may include multiple wirings. Multiple wirings may include a scan signal line SL, an operation control signal line ECL, an emission control signal line (see ECL2 of FIG. 3), a data line DTL, an initialization voltage line VIL, a first voltage line VDL, and a second voltage line VSL. Although not illustrated, the display apparatus 10 may further include other wirings. FIG. 2 illustrates only the schematic disposition of multiple wirings.

The scan signal line SL and the operation control signal line ECL may extend in a first direction DR1. The scan signal line SL and the operation control signal line ECL may be electrically connected to a driver SDR. The driver SDR may include a scan driver circuit and an emission signal control circuit. The driver SDR may be disposed in the non-display area NDA located on one side of the display area DPA in the first direction DR1, but the disclosure is not limited thereto. In some embodiments, the driver SDR may be disposed in the non-display areas NDA located on both sides of the display area DPA in the first direction DR1 and may include a scan driving circuit and an emission signal control circuit. The scan signal line SL may be electrically connected to the driver SDR including the scan driving circuit, and the operation control signal line ECL may be electrically connected to the driver SDR including the operation signal control circuit. The driver SDR may be electrically connected to a signal connection wiring CWL. At least one end of the signal connection wiring CWL may form a pad WPD_CW on the non-display area NDA so as to be electrically connected to an external device.

The data line DTL may extend in a second direction DR2 crossing the first direction DR1. The initialization voltage line VIL may extend in the second direction DR2 and may further include a portion branched in the first direction DR1 from the portion extending in the second direction DR2. The first voltage line VDL and the second voltage line VSL may also include a portion extending in the first direction DR1 and a portion connected thereto and extending in the second direction DR2. The first voltage line VDL and the second voltage line VSL may each have a mesh structure, but the disclosure is not limited thereto. Although not illustrated, each of the pixels PX of the display apparatus 10 may be electrically connected to at least one scan signal line SL, the data line DTL, the operation control signal line ECL, the emission control signal line ECL2, the initialization voltage line VIL, the first voltage line VDL, and the second voltage line VSL.

The data line DTL, the initialization voltage line VIL, the first voltage line VDL, and the second voltage line VSL may be electrically connected to at least one wiring pad WPD. The at least one wiring pad WPD may be disposed in the non-display area NDA. In an embodiment, a wiring pad WPD_DT of the data line DTL (hereinafter referred to as a 'data pad') may be disposed in a pad area PDA located on one side of the display area DPA in the second direction DR2, and a wiring pad WPD_VI of the initialization voltage line VIL (hereinafter referred to as an 'initialization voltage pad'), a wiring pad WPD_VDD of the first voltage line VDL (hereinafter referred to as a 'first power pad'), and a wiring pad WPD_VSS of the second voltage line VSL (hereinafter referred to as a 'second power pad') may be disposed in a pad area PDA located on another side of the display area DPA in the second direction DR2. As another example, the data pad WPD_DT, the initialization voltage pad WPD_VI, the first power pad WPD_VDD, and the second power pad WPD_VSS may all be disposed in the same area, for example, the non-display area NDA located above the display area DPA. The external devices may be mounted on the wiring pads WPD. The external devices may be mounted on the wiring pads WPD through an anisotropic conductive film, ultrasonic bonding, etc.

The pixels PX of the display apparatus 10 may each include a pixel driving circuit. The wirings described above may pass through the pixels PX or surroundings thereof and may apply driving signals to the pixel driving circuits. Each of the pixel driving circuits may include transistors and capacitors. The number of transistors and capacitors in each of the pixel driving circuits may be variously changed. Hereinafter, a case where the pixel driving circuit has a 6T2C structure including six transistors and two capacitors is described as an example, but the disclosure is not limited thereto, and the pixel driving circuit may also have other various modified pixel structures, for example, a 2T1C structure, a 3T1C structure, or a 7T1C structure.

FIG. 3 is a schematic diagram of an equivalent circuit of a pixel according to an embodiment.

Referring to FIG. 3, each of pixels PX of a display apparatus according to an embodiment may include a pixel circuit PC and an organic light-emitting diode LD electrically connected thereto.

As illustrated in FIG. 3, the pixel circuit PC may include multiple thin-film transistors T1 to T6, a storage capacitor Cst, and a holding capacitor Chold. Multiple thin-film transistors T1 to T6, the storage capacitor Cst, and the holding capacitor Chold may be connected to signal lines SL1, SL2, ECL, and DTL, an initialization voltage line VIL, a reference voltage line RFL, a first voltage line VDL, and a second voltage line VSL.

Multiple thin-film transistors T1 to T6 may include a driving transistor T1, a switching transistor T2, a reference voltage transistor T3, an initialization transistor T4, an operation control transistor T5, and an emission control transistor T6.

The organic light-emitting diode LD may include a pixel electrode and an opposite electrode. The pixel electrode of the organic light-emitting diode LD may be connected to the driving transistor T1 to receive a driving current, and the opposite electrode of the organic light-emitting diode LD may receive a second power supply voltage ELVSS. The organic light-emitting diode LD may generate light with a luminance corresponding to the driving current.

The signal lines may include a first scan signal line SL1 to transmit a writing signal (scan signal) GW, a second scan signal line SL2 to transmit a reference voltage signal GR, a third scan signal line SL3 to transmit an initialization signal GI, an operation control signal line ECL to transmit an operation control signal EM, an emission control signal line ECL2 to transmit an emission control signal EMB, and a data line DTL crossing the first scan signal line SL1 to transmit a data signal VDATA.

The initialization voltage line VIL may transmit an initialization voltage Vint for initializing the pixel electrode of the organic light-emitting diode LD, the reference voltage line RFL may transmit a reference voltage VREF to a driving gate electrode of the driving transistor T1, and the first voltage line VDL may transmit a first power supply voltage ELVDD that is a driving voltage of the driving transistor T1.

The driving gate electrode of the driving transistor T1 may be connected to the storage capacitor Cst via a first node N1, a drain region of the driving transistor T1 may be connected to the first voltage line VDL through the operation control transistor T5, and a source region of the driving transistor T1 may be electrically connected to the pixel electrode of the organic light-emitting diode LD via a second node N2. The driving transistor T1 may receive the data signal VDATA according to the switching operation of the switching transistor T2 and supply the driving current to the organic light-emitting diode LD. For example, the driving transistor T1 may control the amount of current flowing to the organic light-emitting diode LD in response to a voltage applied to the first node N1 that changes according to the data signal VDATA.

A switching gate electrode of the switching transistor T2 may be connected to the first scan signal line SL1 to transmit the writing signal GW, one of a source region and a drain region of the switching transistor T2 may be connected to the data line DTL, and another of the source region and the drain region of the switching transistor T2 may be connected to the driving gate electrode of the driving transistor T1 via the first node N1. The switching transistor T2 may transmit the data signal VDATA from the data line DTL to the first node N1 in response to a voltage applied to the first scan signal line SL1. For example, the switching transistor T2 may be turned on in response to the writing signal GW received through the first scan signal line SL1 and perform a switching operation to transmit the data signal VDATA received through the data line DTL to the driving transistor T1 via the first node N1.

A reference voltage gate electrode of the reference voltage transistor T3 may be connected to the second scan signal line SL2 to transmit the reference voltage signal GR, one of a source region and a drain region of the reference voltage transistor T3 may be connected to the reference voltage line RFL, and another of the source region and the drain region of the reference voltage transistor T3 may be connected to the driving gate electrode of the driving transistor T1 via the first node N1. The reference voltage transistor T3 may transmit the reference voltage VREF from the reference voltage line RFL to the first node N1 in response to a voltage applied to the second scan signal line SL2. When necessary, the second scan signal line SL2 may be a first scan signal line SL1 of a pixel belonging to a previous row, which is adjacent to the pixel PX illustrated in FIG. 3 and electrically connected to the same data line DTL. For example, the reference voltage signal GR may be referred to as a previous writing signal (a previous scan signal).

An initialization gate electrode of the initialization transistor T4 may be connected to the third scan signal line SL3, one of a source region and a drain region of the initialization transistor T4 may be connected to the pixel electrode of the organic light-emitting diode LD, and another of the source region and the drain region of the initialization transistor T4 may be connected to the initialization voltage line VIL to receive the initialization voltage Vint. The initialization transistor T4 may be turned on in response to the initialization signal GI received through the third scan signal line SL3 and initialize the pixel electrode of the organic light-emitting diode LD. When necessary, the third scan signal line SL3 may be a writing signal line of a pixel belonging to a next row, which is adjacent to the pixel PX illustrated in FIG. 3 and electrically connected to the same data line DTL. For example, the initialization signal GI may be referred to as a next writing signal (a next scan signal).

An operation control gate electrode of the operation control transistor T5 may be connected to the operation control signal line ECL, one of a source region and a drain region of the operation control transistor T5 may be connected to the first voltage line VDL, and another of the source region and the drain region of the operation control transistor T5 may be connected to the drain region of the driving transistor T1. The operation control transistor T5 may be turned on in response to the operation control signal EM received through the operation control signal line ECL and transmit the first power supply voltage (driving voltage) ELVDD to the organic light-emitting diode LD so that the driving current flows to the organic light-emitting diode LD.

An emission control gate electrode of the emission control transistor T6 may be connected to the emission control signal line ECL2, one of a source region and a drain region of the emission control transistor T6 may be connected to the source region of the driving transistor T1 via the second node N2, and another of the source region and the drain region of the emission control transistor T6 may be connected to the pixel electrode of the organic light-emitting diode LD. The emission control transistor T6 may be turned on in response to the emission control signal EMB received through the emission control signal line ECL2 and transmit the first power supply voltage ELVDD to the organic light-emitting diode LD so that the driving current flows to the organic light-emitting diode LD.

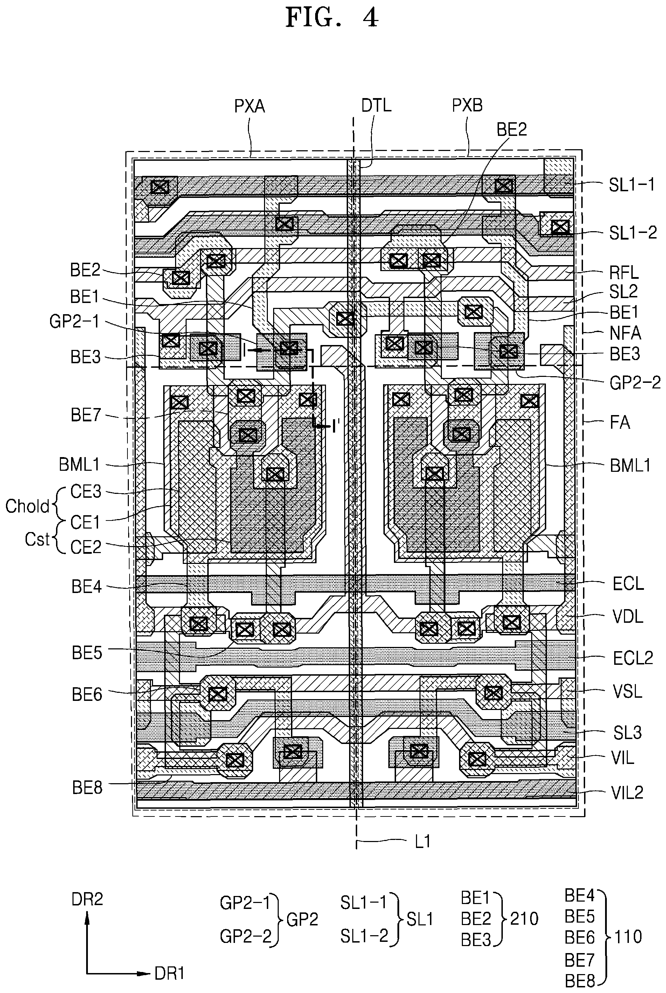

The storage capacitor Cst may include a first capacitor electrode (see CE1 of FIG. 4) and a second capacitor electrode (see CE2 of FIG. 4). The first capacitor electrode (see CE1 of FIG. 4) of the storage capacitor Cst may be connected to the source region of the driving transistor T1 via the second node N2, and the second capacitor electrode (see CE2 of FIG. 4) of the storage capacitor Cst may be connected to the driving gate electrode of the driving transistor T1 via the first node N1. The storage capacitor Cst may store electric charges corresponding to the difference between the voltage of the driving gate electrode of the driving transistor T1 and the initialization voltage Vint. The storage capacitor Cst may be a first capacitor.

The holding capacitor Chold may include a third capacitor electrode (see CE3 of FIG. 4) and a fourth capacitor electrode (not shown). The third capacitor electrode (see CE3 of FIG. 4) of the holding capacitor Chold may be connected to the first voltage line VDL, and the fourth capacitor electrode may be connected to the source region of the driving transistor T1 via the second node N2. The fourth capacitor electrode may be connected to the first capacitor electrode CE1 of the storage capacitor Cst. A compensation voltage that compensates for a threshold voltage (Vth) of the driving transistor T1 may be stored in the holding capacitor Chold. The holding capacitor Chold may be a second capacitor.

A detailed operation of each of the pixels PX according to an embodiment is as follows.

During an initialization period, in case that the initialization signal GI is supplied through the third scan signal line SL3, the initialization transistor T4 may be turned on and the pixel electrode of the organic light-emitting diode LD may be initialized by the initialization voltage Vint supplied from the initialization voltage line VIL. Of course, the source region of the driving transistor T1 electrically connected to the pixel electrode of the organic light-emitting diode LD by the second node N2 and the fourth capacitor electrode of the holding capacitor Chold may also be initialized. As described above, the third scan signal line SL3 may be a first scan signal line SL1 of a pixel belonging to a next row, which is adjacent to the pixel PX illustrated in FIG. 3 and electrically connected to the same data line DTL. For example, the initialization signal GI may be referred to as a next writing signal (a next scan signal).

During a compensation period, in case that the reference voltage signal GR is supplied through the second scan signal line SL2, the reference voltage transistor T3 may be turned on and the reference voltage VREF supplied from the reference voltage line RFL may be transmitted to the driving gate electrode of the driving transistor T1 to compensate for the threshold voltage (Vth) of the driving transistor T1. The compensation voltage that compensates for the threshold voltage (Vth) of the driving transistor T1 may be stored in the holding capacitor Chold. As described above, when necessary, the second scan signal line SL2 may be a first scan signal line SL1 of a pixel belonging to a previous row, which is adjacent to the pixel PX illustrated in FIG. 3 and electrically connected to the same data line DTL. For example, the reference voltage signal GR may be referred to as a previous writing signal (a previous scan signal).

During a data programming period, in case that the writing signal GW is supplied through the first scan signal line SL1, the switching transistor T2 may be turned on in response to the writing signal GW. For example, a voltage corresponding to the data signal VDATA supplied from the data line DTL may be applied to the driving gate electrode of the driving transistor T1. The second capacitor electrode CE2 of the storage capacitor Cst is connected to the driving gate electrode of the driving transistor T1 via the first node N1 and the first capacitor electrode CE1 of the storage capacitor Cst is connected to the fourth capacitor electrode of the holding capacitor Chold that stores the compensation voltage for which the threshold voltage (Vth) of the driving transistor T1 is compensated via the second node N2, and thus, the data voltage for which the threshold voltage (Vth) of the driving transistor T1 is compensated is stored in the storage capacitor Cst.

During an emission period, the operation control transistor T5 may be turned on in response to the operation control signal EM supplied from the operation control signal line ECL. The second capacitor electrode CE2 of the storage capacitor Cst is connected to the driving gate electrode of the driving transistor T1 via the first node N1 and the first capacitor electrode CE1 of the storage capacitor Cst is connected to the source region of the driving transistor T1 via the first node N1, and thus, the driving current corresponding to the data signal VDATA flows to the organic light-emitting diode LD, regardless of the threshold voltage (Vth) of the driving transistor T1, by the data voltage for which the threshold voltage (Vth) of the driving transistor T1 is compensated, wherein the data voltage is stored in the storage capacitor Cst.

As described above, each of multiple thin-film transistors T1 to T6 may include an oxide semiconductor. Because the oxide semiconductor has high carrier mobility and low leakage current, the voltage drop is not great even in case that the driving time increases. For example, in the case of the oxide semiconductor, low-frequency driving is possible because the color change of the image according to the voltage drop is not great even during low-frequency driving. Because each of multiple transistors T1 to T6 includes the oxide semiconductor, the display apparatus in which an occurrence of leakage current is prevented and power consumption is reduced may be implemented.

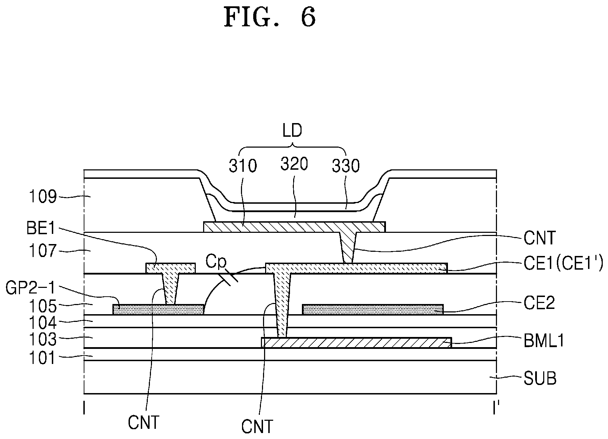

Meanwhile, because the oxide semiconductor is sensitive to light, the amount of current or the like may be changed due to external light. Accordingly, external light may be absorbed or reflected by disposing a metal layer below the oxide semiconductor. Thus, as illustrated in FIG. 3, the switching transistor T2, the reference voltage transistor T3, the initialization transistor T4, and the operation control transistor T5 each including an oxide semiconductor layer may have gate electrodes above and below the oxide semiconductor layer. In addition, in the case of the driving transistor T1, a metal layer may be disposed below the oxide semiconductor layer. For example, when viewed from a direction perpendicular to an upper surface of a substrate (see SUB of FIG. 6) (a direction perpendicular to DR1 and DR2, e.g., in a plan view), the metal layer disposed below the oxide semiconductor layer may overlap the oxide semiconductor layer.

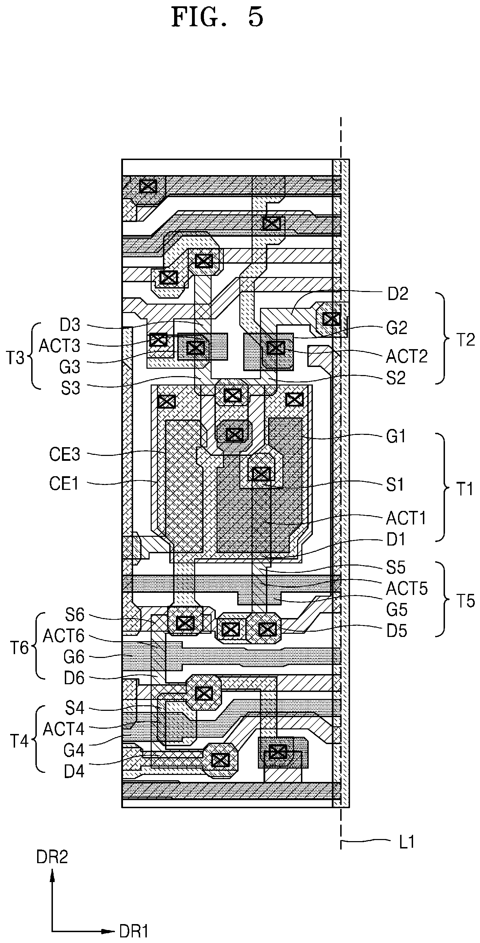

FIG. 4 is a schematic layout diagram illustrating a portion of an area including a first pixel and a second pixel in a display area of the display apparatus of FIG. 1, and FIG. 5 is a schematic layout diagram illustrating positions of thin-film transistors T1 to T6 in the first pixel. FIG. 6 is a schematic cross-sectional view schematically illustrating the display apparatus of FIG. 4 taken along line I-I' of FIG. 4, and FIGS. 7 to 11 are schematic layout diagrams illustrating components of the display apparatus illustrated in FIG. 4, including thin-film transistors T1 to T6, a storage capacitor Cst, and a holding capacitor Chold, on a layer basis.

In FIGS. 4 to 11, two sides in the first direction DR1 may be respectively referred to as a left side and a right side and two sides in the second direction DR2 may be respectively referred to as an upper side and a lower side. For convenience of explanation, FIGS. 4 to 11 also illustrate a portion of another pixel located below a first pixel PXA and a second pixel PXB (or another side in the second direction DR2). The first pixel PXA and the second pixel PXB may correspond to any one of areas surrounded by an alternated long and short dash line among the areas illustrated in FIGS. 4 to 11, and the others thereof may correspond to a portion of another pixel PX adjacent thereto in the second direction DR2. Hereinafter, the drawings illustrated to describe each of the pixels PX may be understood in the same manner as described above.

Referring to FIGS. 4 to 11, the display apparatus 10 according to an embodiment may include multiple pixels PX. Each of multiple pixels PX may include at least one organic light-emitting diode LD and pixel circuit elements for driving the at least one organic light-emitting diode LD. As described above, each of the pixels PX may include multiple thin-film transistors T1 to T6, the storage capacitor Cst, and the holding capacitor Chold as the pixel circuit elements. Each of the pixels PX may be electrically connected to the data line DTL, the scan signal line SL, the operation control signal line ECL, the emission control signal line ECL2, the first voltage line VDL, the second voltage line VSL, the reference voltage line RFL, and the initialization voltage line VIL.

The display apparatus 10 according to an embodiment may include multiple pixels PX in which the pixel circuit elements is differently disposed. The display apparatus 10 may include the first pixel PXA and the second pixel PXB, and the disposition of pixel circuit elements in the first pixel PXA may be different from the disposition of pixel circuit elements in the second pixel PXB.

The first pixel PXA and the second pixel PXB may be disposed adjacent to each other in the first direction DR1 and may include a symmetrical area FA in which the pixel circuit elements are symmetrically disposed therein and an asymmetrical area NFA in which the pixel circuit elements are asymmetrically disposed therein, with respect to an imaginary line L1 located at the boundary between the first pixel PXA and the second pixel PXB. The imaginary line L1 is located in the center of the boundary in the first direction DR1.

The first pixel PXA and the second pixel PXB may share the data line DTL with each other. The data line DTL may be disposed at the boundary between the first pixel PXA and the second pixel PXB, may extend in the second direction DR2, and may be disposed along the imaginary line L1. In order for the first pixel PXA and the second pixel PXB to share the data line DTL with each other, the symmetrical area FA, which is a portion of the pixel circuit elements disposed in each of the first pixel PXA and the second pixel PXB, may have a symmetrical disposition structure with respect to the data line DTL. The asymmetrical area NFA, which is another portion of the pixel circuit elements disposed in each of the first pixel PXA and the second pixel PXB, may have an asymmetrical disposition structure with respect to the data line DTL.

The first capacitor electrode CE1 connected to the second node N2, which is a source node, may be disposed in the symmetrical area FA. The asymmetrical area NFA may be an area adjacent to the first capacitor electrode CE1. The switching transistor T2 connected to the first node N1, which is a gate node, may be disposed in the asymmetrical area NFA. A capacitance Cp may be formed between the first capacitor electrode CE1 and a switching gate electrode GP2-1 of the switching transistor T2. Because the pixel circuit elements are asymmetrically disposed adjacent to the source node, the display apparatus 10 according to an embodiment may maintain the capacitance Cp constant even in case that an overlay deviation occurs. The disposition and structure of the first pixel PXA and the second pixel PXB is described in more detail below.

Firstly, the cross-sectional structure and layout of each of the pixels PX is described in detail. The display apparatus 10 may include a substrate SUB and pixel circuit elements may be disposed on the substrate SUB. The substrate SUB may include an insulating material, such as glass, quartz, or polymer resin. The substrate SUB may be a rigid substrate and may be a flexible substrate that is bendable, foldable, or rollable.

A buffer layer 101 may be disposed on the substrate SUB. The buffer layer 101 may be disposed on the entire surface of the substrate SUB. The buffer layer 101 may be formed on the substrate SUB so as to protect the thin-film transistors of the pixel PX from moisture penetrating through the substrate SUB that is vulnerable to moisture permeation. The buffer layer 101 may perform a surface planarization function. The buffer layer 101 may include multiple inorganic layers that are alternately stacked. For example, the buffer layer 101 may be formed as a multilayer in which one or more inorganic layers selected from a silicon oxide layer (SiOₓ), a silicon nitride layer (SiNₓ), and a silicon oxynitride (SiON) are alternately stacked.

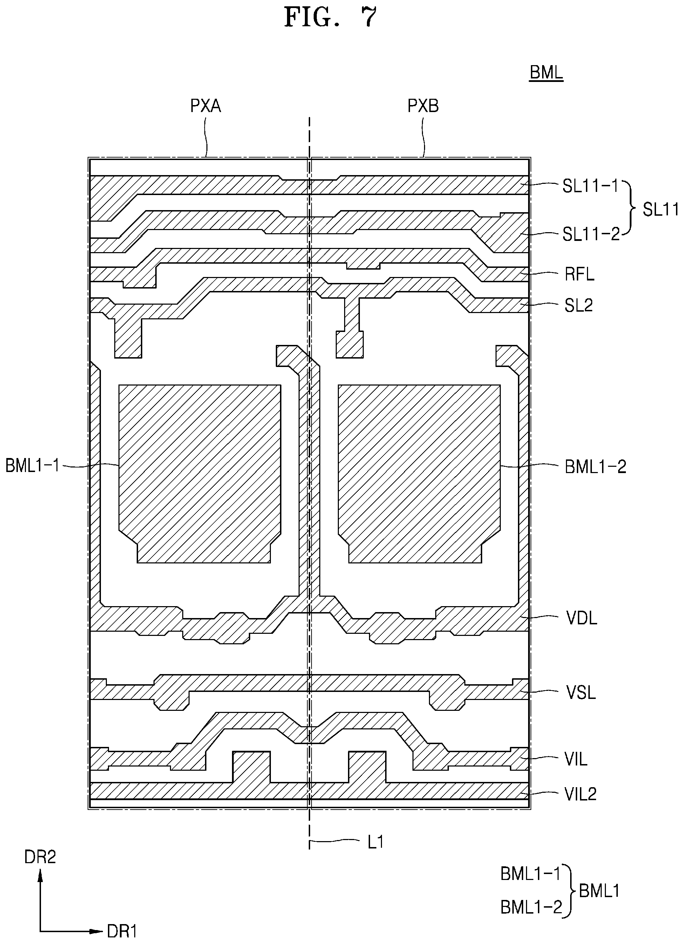

A bottom metal layer BML as illustrated in FIG. 7 may be disposed on the buffer layer 101. The bottom metal layer BML may include a first lower scan signal line SL11, a reference voltage line RFL, a second scan signal line SL2, a lower capacitor electrode BML1, a first voltage line VDL, a second voltage line VSL, a first initialization voltage line VIL, and a second initialization voltage line VIL2. Among them, the first lower scan signal line SL11, the reference voltage line RFL, the second scan signal line SL2, the first voltage line VDL, the second voltage line VSL, the first initialization voltage line VIL, and the second initialization voltage line VIL2 may extend in the first direction DR1.

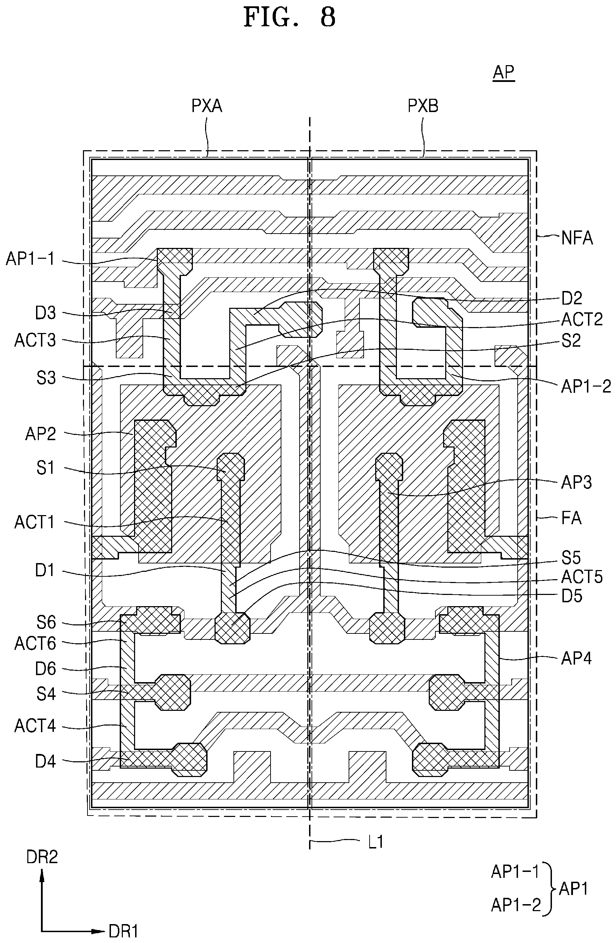

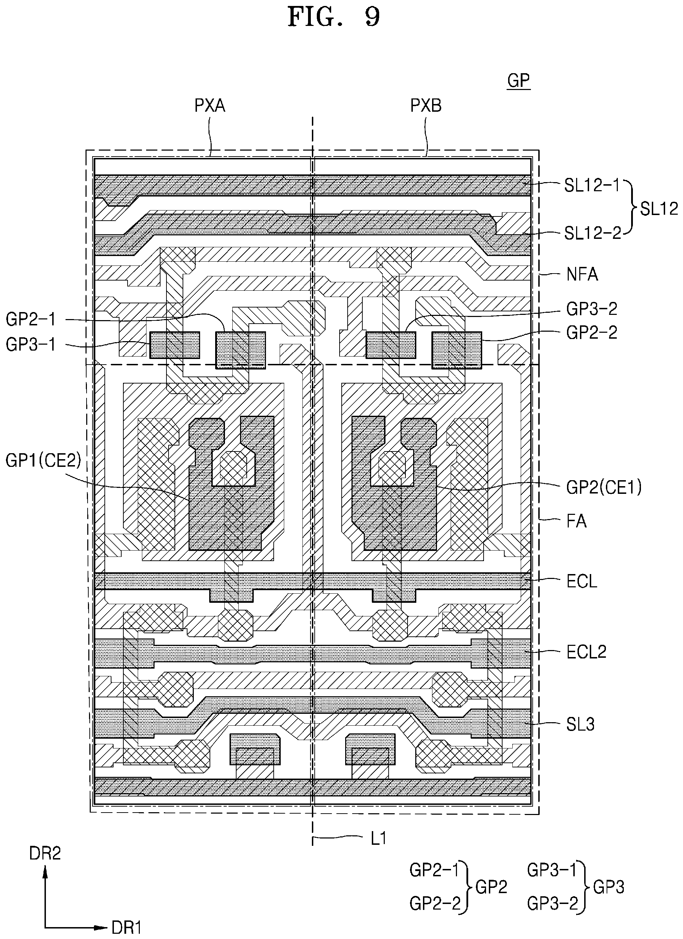

The first lower scan signal line SL11 may be disposed above the first lower scan signal line SL11 and may be electrically connected through a contact hole to a first upper scan signal line (see SL12 of FIGS. 8 and 9) extending in the first direction DR1, which is to be described below. A set of the first lower scan signal line SL11 and the first upper scan signal line SL12 may correspond to the first scan signal line SL1 of FIG. 3.

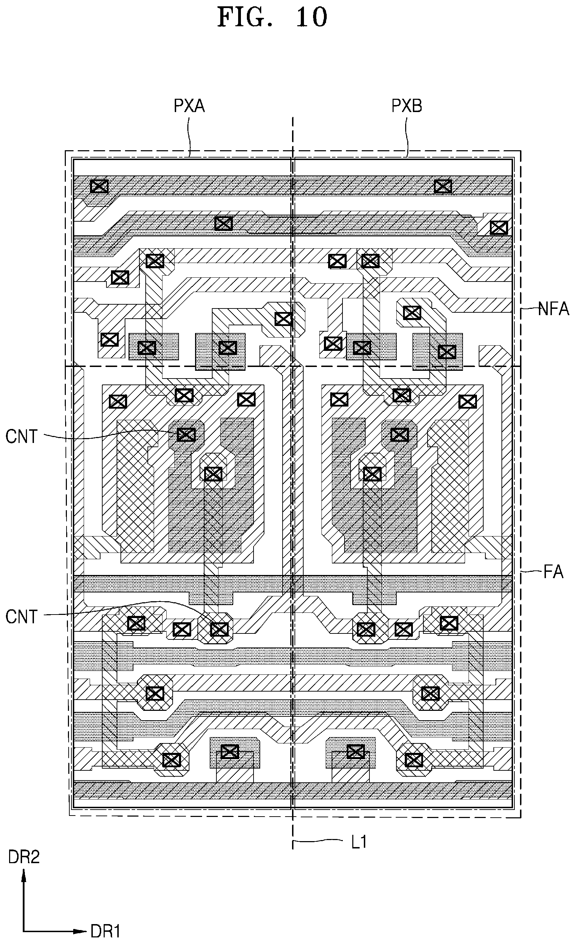

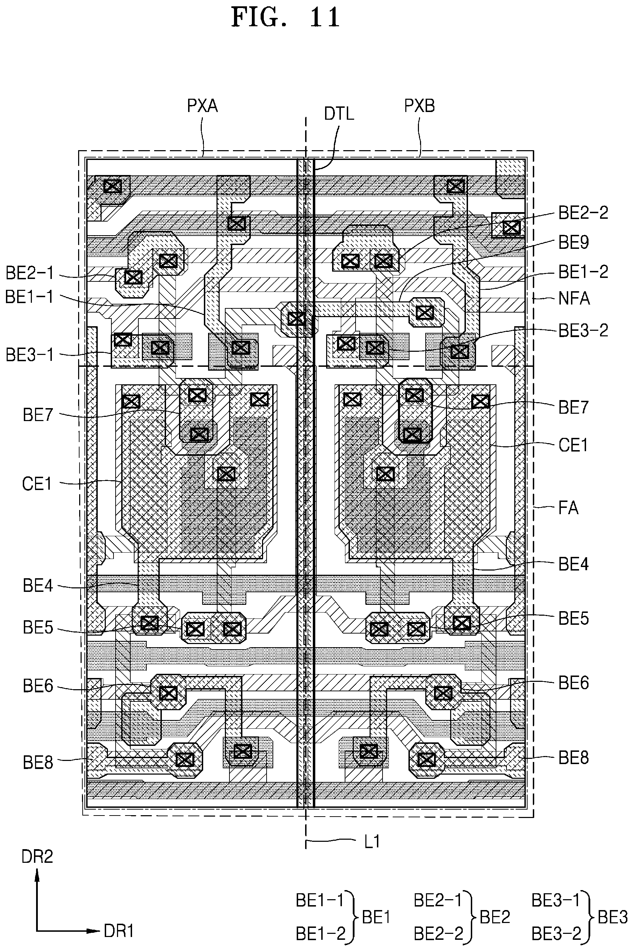

The first lower scan signal line SL11 may include a first-1 lower scan signal line SL11-1 and a first-2 lower scan signal line SL11-2 that extend apart from each other along the first direction DR1. One of the first-1 lower scan signal line SL11-1 and the first-2 lower scan signal line SL11-2 may be electrically connected to a first switching gate electrode GP2-1 of the first pixel PXA through a first-1 connection electrode (see BE1-1 of FIGS. 10 and 11) to be described below, and another of the first-1 lower scan signal line SL11-1 and the first-2 lower scan signal line SL11-2 may be electrically connected to a second switching gate electrode GP2-2 of the second pixel PXB through a first-2 connection electrode (see BE1-2 of FIGS. 10 and 11) to be described below.

The reference voltage line RFL may be electrically connected to a first semiconductor layer (see AP1 of FIG. 8) via a second connection electrode (see BE2 of FIG. 11) to be described below. The reference voltage line RFL may correspond to the reference voltage line RFL of FIG. 3.

The second scan signal line SL2 may be electrically connected to a third gate electrode layer (see GP3 of FIGS. 8 and 11), which is a reference voltage gate electrode, through a third connection electrode BE3. As illustrated in FIG. 7, the second scan signal line SL2 may have a protrusion in each of the first pixel PXA and the second pixel PXB and may be electrically connected to a third-1 gate electrode layer GP3-1 and a third-2 gate electrode layer GP3-2, which are reference voltage gate electrodes through a third-1 connection electrode BE3-1 and a third-2 connection electrode BE3-2. The protrusion of the second scan signal line SL2 in the first pixel PXA and the protrusion of the second scan signal line SL2 in the second pixel PXB may have different shapes from each other. For example, the second scan signal line SL2 may have an asymmetrical structure with respect to the imaginary line L1.

The lower capacitor electrode BML1 may have an isolated shape in each of the pixels PX. The lower capacitor electrode BML1 may be electrically connected to the first capacitor electrode CE1 located thereabove through a contact hole. The lower capacitor electrode BML1 may have a symmetrical structure with respect to the second direction DR2.

The first voltage line VDL may be electrically connected to the first capacitor electrode CE1 through a contact hole. The first voltage line VDL, the second voltage line VSL, the first initialization voltage line VIL, and the second initialization voltage line VIL2 may have a symmetrical structure with respect to the imaginary line L1.

The bottom metal layer BML may include metal, alloy, or conductive metal oxide. For example, the bottom metal layer BML may include silver (Ag), an Ag-containing alloy, molybdenum (Mo), a Mo-containing alloy, aluminum (Al), an Al-containing alloy, aluminum nitride (AIN), tungsten (W), tungsten nitride (WN), copper (Cu), nickel (Ni), chromium (Cr), chromium nitride (CrN), titanium (Ti), tantalum (Ta), platinum (Pt), or scandium (Sc). The bottom metal layer BML may have a multilayer structure. For example, the bottom metal layer BML may have a two-layer structure including an about 3,500 A-thick aluminum layer and an about 300 A-thick titanium layer.

A first insulating layer 103 may be disposed on the substrate SUB and cover the bottom metal layer BML. The first insulating layer 103 may include an insulating material. For example, the first insulating layer 103 may be formed as a multilayer in which one or more inorganic layers selected from a silicon oxide layer (SiOₓ), a silicon nitride layer (SiNₓ), and a silicon oxynitride (SiON) are alternately stacked. The first insulating layer 103 may prevent metal atoms or impurities from diffusing from the substrate SUB or the like into a semiconductor layer AP disposed thereon.

As illustrated in FIG. 8, the semiconductor layer AP may be disposed on the first insulating layer 103. In FIG. 8, for convenience, the semiconductor layer AP is illustrated together with the bottom metal layer BML. As described above, the semiconductor layer AP may include an oxide semiconductor material. For example, the semiconductor layer AP may include indium tin gallium zinc oxide (ITGZO) having a thickness of about 300 Å. The driving transistor T1, the switching transistor T2, the reference voltage transistor T3, the initialization transistor T4, the operation control transistor T5, and the emission control transistor T6 may be disposed along the semiconductor layer AP, as illustrated in FIGS. 5 and 8. As illustrated in FIG. 8, the semiconductor layer AP may include a first semiconductor pattern AP1, a second semiconductor pattern AP2, a third semiconductor pattern AP3, and a fourth semiconductor pattern AP4, which are spaced apart from each other.

A drain region D2, an active region ACT2, and a source region S2 of a switching transistor T2 and a drain region D3, an active region ACT3, and a source region S3 of a reference voltage transistor T3 may be disposed on the first semiconductor pattern AP1. The first semiconductor pattern AP1 may be referred to as a switching semiconductor layer or a reference voltage semiconductor layer.

The second semiconductor pattern AP2 may be electrically connected to the first voltage line VDL and may correspond to the third capacitor electrode (see CE3 of FIG. 4) of the holding capacitor Chold. A drain region D1, an active region ACT1, and a source region S1 of a driving transistor T1 and a drain region D5, an active region ACT5, and a source region S5 of an operation control transistor T5 may be disposed on the third semiconductor pattern AP3. The third semiconductor pattern AP3 may be referred to as a driving semiconductor layer or an operation control semiconductor layer.

A drain region D4, an active region ACT4, and a source region S4 of an initialization transistor T4 and a drain region D6, an active region ACT6, and a source region S6 of an emission control transistor T6 may be disposed on the fourth semiconductor pattern AP4. The fourth semiconductor pattern AP4 may be referred to as an initialization semiconductor layer or an emission control semiconductor layer.

The second semiconductor pattern AP2, the third semiconductor pattern AP3, and the fourth semiconductor pattern AP4 of each of the first pixel PXA and the second pixel PXB may be symmetrically disposed with respect to the imaginary line L1. In contrast, a first-1 semiconductor pattern AP1-1 of the first pixel PXA and a first-2 semiconductor pattern AP1-2 of the second pixel PXB may be asymmetrically disposed with respect to the imaginary line L1. For example, the first-1 semiconductor pattern AP1-1 may be electrically connected to the data line DTL through a contact hole, and the first-2 semiconductor pattern AP1-2 may be electrically connected to the data line DTL through a ninth connection electrode (see BE9 of FIG. 11) to be described below.

A second insulating layer 104 may be disposed on the substrate SUB and cover the semiconductor layer AP. The second insulating layer 104 may include an insulating material. For example, the second insulating layer 104 may include an inorganic insulating layer, such as silicon oxide, silicon nitride, silicon oxynitride, or aluminum oxide.

As illustrated in FIG. 6, a first conductive layer GP may be disposed on the second insulating layer 104. In FIG. 9, for convenience, the first conductive layer GP is illustrated together with the bottom metal layer BML and the semiconductor layer AP. The first conductive layer GP may include a first upper scan signal line SL12, a first gate electrode layer GP1, a second gate electrode layer GP2, a third gate electrode layer GP3, an operation control signal line ECL, an emission control signal line ECL2, and a third scan signal line SL3. The first conductive layer GP may also be referred to as a gate layer.

The first gate electrode layer GP1 may also be referred to as a driving gate electrode layer. The first gate electrode layer GP1 may overlap the semiconductor layer AP therebelow. A portion of the first gate electrode layer GP1 that overlaps the semiconductor layer AP, for example, a portion of the semiconductor layer AP that overlaps a driving active region ACT1 may be the driving gate electrode (see G1 of FIG. 5). The first gate electrode layer GP1 may function as the gate electrode of the driving transistor T1 and may function as the second capacitor electrode CE2 of the storage capacitor Cst by overlapping the first capacitor electrode CE1 to be described below. For example, the first gate electrode layer GP1 may electrically connect the storage capacitor Cst, the gate electrode of the driving transistor T1, the switching transistor T2, and the reference voltage transistor T3 to each other. The first gate electrode layer GP1 may be understood as serving as the first node N1 of FIG. 3, which is the gate node.

A portion of the second gate electrode layer GP2 may also overlap the semiconductor layer AP therebelow. The second gate electrode layer GP2 may also be referred to as a switching gate electrode layer. A portion of the second gate electrode layer GP2 that overlaps the semiconductor layer AP, for example, a portion of the semiconductor layer AP that overlaps a switching active region ACT2 may be a switching gate electrode G2. The second gate electrode layer GP2 may have an isolated shape and may function as the gate electrode of the switching transistor T2.

A portion of the third gate electrode layer GP3 may also overlap the semiconductor layer AP therebelow. The third gate electrode layer GP3 may also be referred to as a reference voltage gate electrode layer. A portion of the third gate electrode layer GP3 that overlaps the semiconductor layer AP, for example, a portion of the semiconductor layer AP that overlaps a reference voltage active region ACT3 may be a reference voltage gate electrode G3. The reference voltage gate electrode G3 may function as the gate electrode of the reference voltage transistor T3.

A portion of the operation control signal line ECL may overlap the semiconductor layer AP therebelow. A portion of the operation control signal line ECL that overlaps the semiconductor layer AP, for example, a portion of the semiconductor layer AP that overlaps an operation control active region ACT5 may be an operation control gate electrode G5. The operation control gate electrode G5 may function as the gate electrode of the operation control transistor T5.

A portion of the emission control signal line ECL2 may overlap the semiconductor layer AP therebelow. A portion of the emission control signal line ECL2 that overlaps the semiconductor layer AP, for example, a portion of the semiconductor layer AP that overlaps an emission control active region ACT6 may be an emission control gate electrode G6. The emission control gate electrode G6 may function as the gate electrode of the emission control transistor T6.

A portion of the third scan signal line SL3 may overlap the semiconductor layer AP therebelow. A portion of the third scan signal line SL3 that overlaps the semiconductor layer AP, for example, a portion of the semiconductor layer AP that overlaps an initialization active region ACT4 may be an initialization gate electrode G4. The initialization gate electrode G4 may function as the gate electrode of the initialization transistor T4.

The first gate electrode layer GP1, the operation control signal line ECL, the emission control signal line ECL2, and the third scan signal line SL3, which are disposed in each of the first pixel PXA and the second pixel PXB, may be symmetrically disposed with respect to the imaginary line L1. As illustrated in FIG. 9, the first gate electrode layer GP1 may have an asymmetrical shape with respect to the second direction DR2, but the first gate electrode layer GP1 of the first pixel PXA and the second gate electrode layer GP2 of the second pixel PXB may have a symmetrical structure with respect to the imaginary line L1.

In contrast, a second-1 gate electrode layer GP2-1 and a third-1 gate electrode layer GP3-1 of the first pixel PXA and a second-2 gate electrode layer GP2-2 and a third-2 gate electrode layer GP3-2 of the second pixel PXB may be asymmetrically disposed with respect to the imaginary line L1. For example, the disposition order of the second-1 gate electrode layer GP2-1 and the third-1 gate electrode layer GP3-1, which are disposed along the first direction DR1 in the first pixel PXA, may be the same as the disposition order of the second-2 gate electrode layer GP2-2 and the third-2 gate electrode layer GP3-2, which are disposed along the first direction DR1 in the second pixel PXB.

The first conductive layer GP may include metal, alloy, conductive metal oxide, or a transparent conductive material. For example, the first conductive layer GP may include silver (Ag), an Ag-containing alloy, molybdenum (Mo), a Mo-containing alloy, aluminum (Al), an Al-containing alloy, aluminum nitride (AIN), tungsten (W), tungsten nitride (WN), copper (Cu), nickel (Ni), chromium (Cr), chromium nitride (CrN), titanium (Ti), tantalum (Ta), platinum (Pt), scandium (Sc), indium tin oxide (ITO), or indium zinc oxide (IZO). The first conductive layer GP may have a multilayer structure. For example, the first conductive layer GP may have a two-layer structure including an a about 300 A-thick titanium layer and an a about 2500 A-thick molybdenum layer.

A third insulating layer 105 may be disposed on the substrate SUB and cover the first conductive layer GP. The third insulating layer 105 may include an insulating material. For example, the third insulating layer 105 may include an inorganic insulating layer, such as silicon oxide, silicon nitride, silicon oxynitride, or aluminum oxide.

As illustrated in FIG. 10, a contact hole CNT may pass through at least one of the first insulating layer 103, the second insulating layer 104, or the third insulating layer 105 and may electrically connect a top metal layer and a bottom metal layer overlapping the contact hole CNT. As illustrated in FIG. 10, it may be confirmed that the contact hole CNT of the first pixel PXA and the contact hole CNT of the second pixel PXB in the symmetrical area FA are symmetrically disposed with respect to the imaginary line L1. In contrast, it may be confirmed that the contact hole CNT of the first pixel PXA and the contact hole CNT of the second pixel PXB in the asymmetrical area NFA are asymmetrically disposed with respect to the imaginary line L1.

A second conductive layer SP (not shown herein) may be disposed on the third insulating layer 105. The second conductive layer SP may include a data line DTL, a first capacitor electrode CE1, a first connection electrode BE1, a second connection electrode BE2, a third connection electrode BE3, a fourth connection electrode BE4, a fifth connection electrode BE5, a sixth connection electrode BE6, a seventh connection electrode BE7, an eighth connection electrode BE8, and a ninth connection electrode BE9. The second conductive layer SP may also be referred to as a source/drain layer.

The data line DTL may be disposed at the boundary between the first pixel PXA and the second pixel PXB and may extend in the second direction. The first pixel PXA and the second pixel PXB may share one data line DTL with each other.

The first capacitor electrode CE1 may have an isolated shape and may be disposed above the second capacitor electrode CE2 and the third capacitor electrode CE3. The first capacitor electrode CE1 may constitute a storage capacitor Cst together with the second capacitor electrode CE2. The first capacitor electrode CE1 may perform the function of the fourth capacitor electrode described above and may constitute a holding capacitor Chold together with the third capacitor electrode CE3. For example, the first capacitor electrode CE1 and the fourth capacitor electrode may be an integrated conductive layer as illustrated in FIG. 11.

The first capacitor electrode CE1 may be electrically connected to the lower capacitor electrode BML1 disposed at the lower portion through a contact hole. For example, the lower capacitor electrode BML1 may function as a capacitor electrode of the storage capacitor Cst and a capacitor electrode of the holding capacitor Chold together with the first capacitor electrode CE1.

The first capacitor electrode CE1 may be integrally formed with the fourth connection electrode BE4. The fourth connection electrode BE4 may be a protruding portion extending from one side of the first capacitor electrode CE1. The first capacitor electrode CE1 may be electrically connected to the first voltage line VDL through the fourth connection electrode BE4. As described above, the first capacitor electrode CE1 may electrically connect the capacitor electrode of the holding capacitor Chold, the capacitor electrode of the storage capacitor Cst, and the driving transistor T1 to each other. The first capacitor electrode CE1 may be understood as serving as the second node N2 of FIG. 3, which is the source node.

The first capacitor electrode CE1 may have a symmetrical structure with respect to the second direction DR2. For example, the fourth connection electrode BE4 may be shifted from the center of the first capacitor electrode CE1, and the fourth connection electrode BE4 of the first pixel PXA and the fourth connection electrode BE4 of the second pixel PXB may be symmetrically disposed with respect to the imaginary line L1. For example, in case that the fourth connection electrode BE4 of the first pixel PXA is disposed on the left side of the first capacitor electrode CE1, the fourth connection electrode BE4 of the second pixel PXB may be disposed on the right side of the first capacitor electrode CE1.

The first connection electrode BE1, the second connection electrode BE2, the third connection electrode BE3, the fourth connection electrode BE4, the fifth connection electrode BE5, the sixth connection electrode BE6, the seventh connection electrode BE7, and the eighth connection electrode BE8 may be disposed in each of the first pixel PXA and the second pixel PXB. A ninth connection electrode BE9 may be further disposed in the second pixel PXB.

One side of the first connection electrode BE1 may be electrically connected to the second gate electrode layer GP2 through a contact hole. Another side of the first connection electrode BE1 may be electrically connected to the first scan signal line SL1 through a contact hole. For example, the first connection electrode BE1 may electrically connect the first scan signal line SL1 to the switching transistor T2.

As described above, the first scan signal line SL1 may have a dual wiring structure of a first-1 scan signal line SL1-1 and a first-2 scan signal line SL1-2. A first-1 connection electrode BE1-1 of the first pixel PXA may be electrically connected to the first-1 scan signal line SL1-1 or the first-2 scan signal line SL1-2. A first-2 connection electrode BE1-2 of the second pixel PXB may be electrically connected to the first-1 scan signal line SL1-1 or the first-2 scan signal line SL1-2. The first-1 connection electrode BE1-1 and the first-2 connection electrode BE1-2 may be asymmetrically disposed with respect to the imaginary line L1 or the data line DTL.

One side of the second connection electrode BE2 may be electrically connected to the reference voltage line RFL through a contact hole. Another side of the second connection electrode BE2 may be electrically connected to one side of the reference voltage drain region D3 of the semiconductor layer AP through a contact hole. For example, the second connection electrode BE2 may electrically connect the reference voltage line RFL to the reference voltage transistor T3. A second-1 connection electrode BE2-1 of the first pixel PXA and a second-2 connection electrode BE2-2 of the second pixel PXB may be asymmetrically disposed with respect to the imaginary line L1 or the data line DTL.

One side of the third connection electrode BE3 may be electrically connected to the second scan signal line SL2 through a contact hole. Another side of the third connection electrode BE3 may be electrically connected to the third gate electrode layer GP3 through a contact hole. For example, the third connection electrode BE3 may electrically connect the second scan signal line SL21 to the gate electrode of the reference voltage transistor T3. A third-1 connection electrode BE3-1 of the first pixel PXA and a third-2 connection electrode BE3-2 of the second pixel PXB may be asymmetrically disposed with respect to the imaginary line L1 or the data line DTL.

The first connection electrode BE1, the second connection electrode BE2, and the third connection electrode BE3 may be disposed in the asymmetrical areas NFA of the first pixel PXA and the second pixel PXB. The second electrodes 210 disposed in the asymmetrical areas NFA of the first pixel PXA and the second pixel PXB may be asymmetrically disposed with respect to the imaginary line L1. The second electrodes 210 may include the first connection electrode BE1, the second connection electrode BE2, and the third connection electrode BE3.

At least one of the second electrodes 210 may be disposed between the first scan signal line SL1 and the first capacitor electrode CE1. For example, the third connection electrode B3 among the second electrodes 210 may be disposed between the first scan signal line SL1 and the first capacitor electrode CE1.

Meanwhile, in order for the first pixel PXA and the second pixel PXB to share the data line DTL with each other, the first electrodes 110 of the second pixel PXB may further include the ninth connection electrode BE9. One side of the ninth connection electrode BE9 may be electrically connected to the data line DTL through a contact hole, and another side of the ninth connection electrode BE9 may be electrically connected to one side of a switching drain region D2 of the semiconductor layer AP through a contact hole. For example, the ninth connection electrode BE9 may electrically connect the data line DTL to the switching transistor T2.

One side of the fifth connection electrode BE5 may be electrically connected to the first voltage line VDL through a contact hole, and another side of the fifth connection electrode BE5 may be electrically connected to an operation control drain region D5 of the semiconductor layer AP through a contact hole. For example, the fifth connection electrode BE5 may connect the first voltage line VDL to the operation control transistor T5.

One side of the sixth connection electrode BE6 may be electrically connected to the second initialization voltage line VIL2 through a contact hole, and another side of the sixth connection electrode BE6 may be connected between an initialization source region S4 of the semiconductor layer AP and an emission control drain region D6 through a contact hole.

One side of the seventh connection electrode BE7 may be electrically connected to the first gate electrode layer GP1 through a contact hole, and another side of the seventh connection electrode BE7 may be connected between a switching source region S2 and a reference voltage source region S3 through a contact hole.

One side of the eighth connection electrode BE8 may be electrically connected to the initialization voltage line VIL through a contact hole, and another side of the eighth connection electrode BE8 may be electrically connected to one side of an initialization drain region D4 of the semiconductor layer AP through a contact hole. For example, the eighth connection electrode BE8 may electrically connect the initialization voltage line VIL to the initialization transistor T4.

The fifth connection electrode BE5, the sixth connection electrode BE6, the seventh connection electrode BE7, and the eighth connection electrode BE8 may be disposed in the symmetrical areas FA of the first pixel PXA and the second pixel PXB. The first electrodes 110 disposed in the symmetrical areas FA of the first pixel PXA and the second pixel PXB may be symmetrically disposed with respect to the imaginary line L1. The first electrodes 110 may include the fifth connection electrode BE5, the sixth connection electrode BE6, the seventh connection electrode BE7, and the eighth connection electrode BE8.

At least one of the first electrodes 110 may be disposed between the first capacitor electrode CE1 and the initialization voltage line VIL. For example, the fifth connection electrode BE5 among the first electrodes 110 may be disposed between the first capacitor electrode CE1 and the initialization voltage line VIL.

The second conductive layer SP may include metal, alloy, conductive metal oxide, or a transparent conductive material. For example, the second conductive layer SP may include silver (Ag), an Ag-containing alloy, molybdenum (Mo), a Mo-containing alloy, aluminum (Al), an Al-containing alloy, aluminum nitride (AIN), tungsten (W), tungsten nitride (WN), copper (Cu), nickel (Ni), chromium (Cr), chromium nitride (CrN), titanium (Ti), tantalum (Ta), platinum (Pt), scandium (Sc), indium tin oxide (ITO), or indium zinc oxide (IZO). For example, the second conductive layer SP may have a multilayer structure including an about 700 A-thick titanium layer, an about 6,000 A-thick aluminum layer, and an a about 300 A-thick titanium layer. The second conductive layer SP may also be referred to as a source/drain layer.

A planarization layer 107 may be disposed on the third insulating layer 105 and may cover the second conductive layer SP. The planarization layer 107 may include an organic insulating material. For example, the planarization layer 107 may include photoresist, benzocyclobutene (BCB), polyimide, hexamethyldisiloxane (HMDSO), polymethylmethacrylate (PMMA), polystyrene, polymer derivatives having a phenolic group, acrylic-based polymer, imide-based polymer, aryl ether-based polymer, amide-based polymer, fluorine-based polymer, p-xylene-based polymer, vinyl alcoholbased polymer, or any mixture thereof. For example, the planarization layer 107 may include a polyimide layer having a thickness of about 1.6 µm.

An organic light-emitting diode LD may be disposed on the planarization layer 107. The organic light-emitting diode LD may include a pixel electrode 310, an intermediate layer 320 including an emission layer, and an opposite electrode 330.

The pixel electrode 310 may be a transmissive (or semi-transmissive) electrode or a reflective electrode. For example, the pixel electrode 310 may include a reflective layer and a transparent or semi-transparent electrode layer disposed on the reflective layer. The reflective layer may include Ag, Mg, Al, Pt, Pd, Au, Ni, Nd, Ir, Cr, or any compound thereof. The transparent or semi-transparent electrode layer may include at least one selected from indium tin oxide (ITO), indium zinc oxide (IZO), zinc oxide (ZnO), indium oxide (In₂O₃), indium gallium oxide (IGO), and aluminum zinc oxide (AZO). For example, the pixel electrode 310 may have a three-layer structure of ITO/Ag/ITO.

A pixel defining layer 100 may be disposed on the planarization layer 107. The pixel defining layer 109 may prevent an electric arc or the like from occurring on the edge of the pixel electrode 310 by increasing the distance between the edge of the pixel electrode 310 and the opposite electrode 330 on the pixel electrode 310. The pixel defining layer 109 may include at least one organic insulating material selected from polyimide, polyamide, acrylic resin, benzocyclobutene (BCB), and phenol resin and may be formed by spin coating or the like.

At least a portion of the intermediate layer 320 of the organic light-emitting diode LD may be disposed in an opening formed by the pixel defining layer 109. An emission area of the organic light-emitting diode LD may be defined by the opening.

The intermediate layer 320 may include an emission layer. The emission layer may include an organic material including a fluorescent or phosphorescent material that emits red light, green light, blue light, or white light. The emission layer may include a low molecular weight organic material or a high molecular weight organic material. Functional layers, such as a hole transport layer (HTL), a hole injection layer (HIL), an electron transport layer (ETL), and an electron injection layer (ElL), may be optionally further disposed below and above the emission layer.

The emission layer may have a patterned shape corresponding to each of the pixel electrodes 310. Layers other than the emission layer included in the intermediate layer 320 may be variously modified. For example, the layers may be integrally formed across the pixel electrodes 310.

The opposite electrode 330 may be a transmissive electrode or a reflective electrode. For example, the opposite electrode 330 may be a transparent or semi-transparent electrode and may include a metal thin-film having a low work function and including Li, Ca, LiF, Al, Ag, Mg, or any compound thereof. The opposite electrode 330 may further include a transparent conductive oxide (TCO) layer, such as ITO, IZO, ZnO, or In₂O₃, disposed on the metal thin-film. The opposite electrode 330 may be integrally formed on the entire display area DPA and disposed above the intermediate layer 320 and the pixel defining layer 109.

As described above, the driving transistor T1 and the like may be n-channel metal-oxide semiconductor field effect transistor (MOSFET) thin-film transistors that include an oxide semiconductor material. For example, the luminance of the organic light-emitting diode LD may be determined according to the potential difference between the driving gate electrode G1 of the driving transistor T1 and the second node N2 that is the source region. The second node N2 may be affected by the capacitance Cp formed between the electrodes in the peripheral area, which may cause a luminance deviation in the organic light-emitting diode LD.

Meanwhile, the first pixel PXA and the second pixel PXB may include pixel circuit elements symmetrically disposed in the entire area with respect to the imaginary line L1 so as to share the data line DTL with each other. For example, in case that an overlay deviation occurs in the gate layer, which is the first conductive layer GP, all pixel circuit elements included in the gate layer may be shifted in one direction. In case that the gate layer is shifted to the left side, the distance between the second node N2 and the first conductive layer GP in the first pixel PXA may decrease and the distance between the second node N2 and the first conductive layer GP in the second pixel PXB may increase. In contrast, in case that the gate layer is shifted to the right side, the distance between the second node N2 and the first conductive layer GP in the first pixel PXA may increase and the distance between the second node N2 and the first conductive layer GP in the second pixel PXB may decrease. For example, in case that the pixel circuit elements of the entire area are symmetrically disposed in the first pixel PXA and the second pixel PXB, the first pixel PXA and the second pixel PXB may emit light with different luminance due to an overlay deviation, which ultimately leads to a deterioration in the quality of the displayed image.

However, as described above, in the display apparatus according to the present embodiment, the first pixel PXA and the second pixel PXB may include the symmetrical area FA and the asymmetrical area NFA. The first electrodes 110 disposed in the symmetrical area FA may be symmetrically disposed with respect to the imaginary line L1 and the second electrodes 210 disposed in the asymmetrical area NFA may be asymmetrically disposed with respect to the imaginary line L1, thereby preventing or minimizing a luminance deviation between the first pixel PXA and the second pixel PXB. Therefore, the display apparatus according to the present embodiment may display high-quality images.

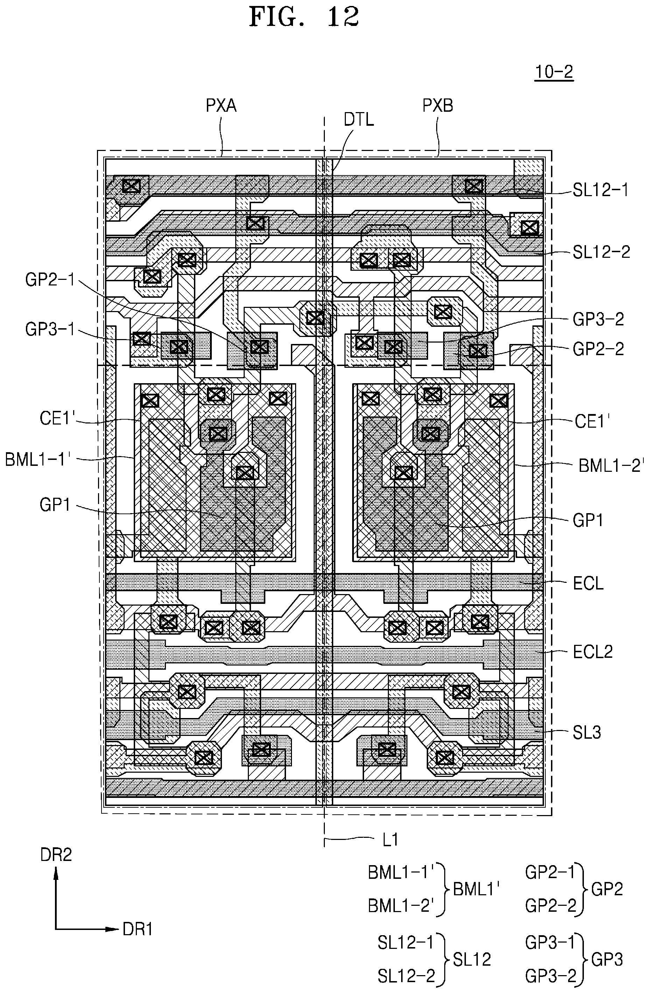

FIG. 12 is a schematic layout diagram illustrating a portion of an area including a first pixel and a second pixel in a display area of a display apparatus according to another embodiment, and

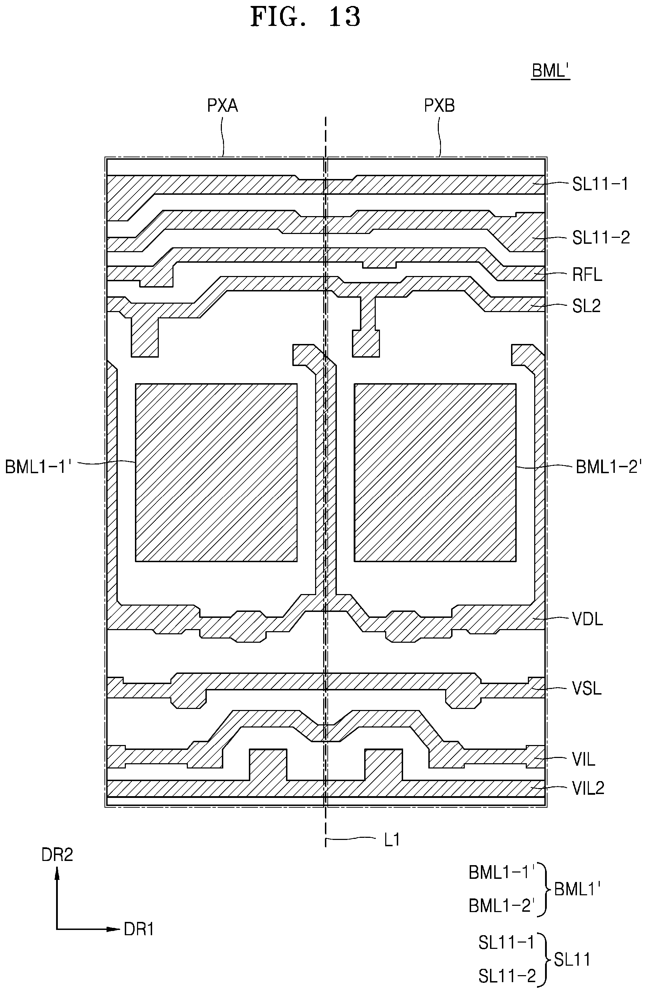

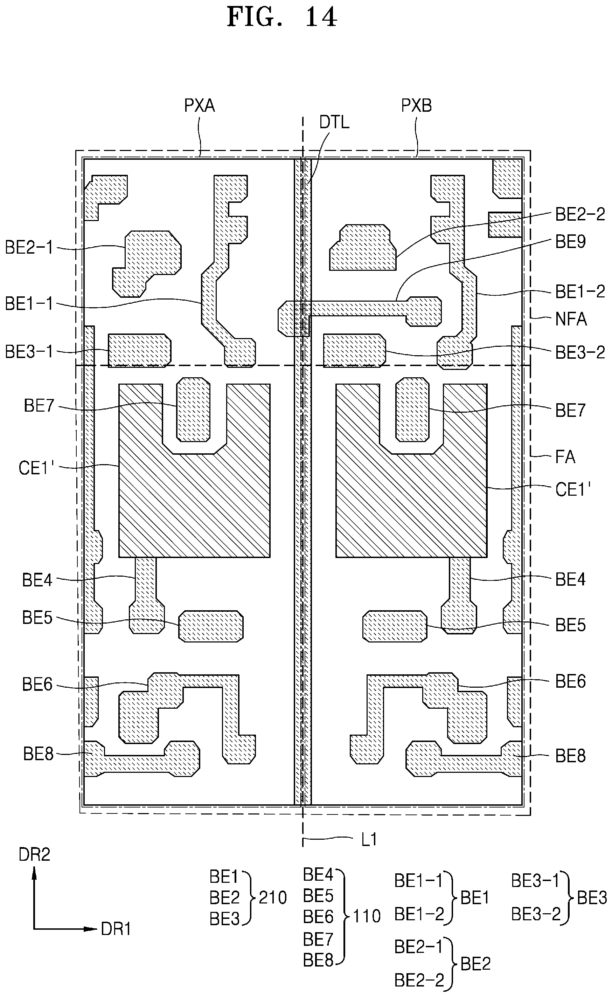

FIGS. 13 and 14 are schematic layout diagrams illustrating components of the display apparatus illustrated in FIG. 12, including thin-film transistors T1 to T6, a storage capacitor Cst, and a holding capacitor Chold, on a layer basis. For the layout diagrams on a layer basis, FIG. 13 illustrates a bottom metal layer BML' and FIG. 14 illustrates a second conductive layer SP. A semiconductor layer AP and a first conductive layer GP are the same as those described above with reference to FIGS. 7 to 11, and thus, a redundant description thereof is omitted.

In FIGS. 12 to 14, two sides in the first direction DR1 may be referred to as a left side and a right side and two sides in the second direction DR2 may be referred to as an upper side and a lower side. For convenience of explanation, FIGS. 12 to 14 also illustrate a portion of another pixel located below a first pixel PXA and a second pixel PXB (or another side in the second direction DR2). The first pixel PXA and the second pixel PXB may correspond to any one of areas surrounded by an alternated long and short dash line among the areas illustrated in FIGS. 12 to 14, and the others thereof may correspond to a portion of another pixel PX adjacent thereto in the second direction DR2. Hereinafter, the drawings illustrated to describe each of the pixels PX may be understood in the same manner as described above.

Referring to FIGS. 12 to 14, a display apparatus 10-2 according to another embodiment may include multiple pixels PX. Each of multiple pixels PX may include at least one organic light-emitting diode LD and pixel circuit elements for driving the at least one organic light-emitting diode LD.

The display apparatus 10-2 according to another embodiment may include multiple pixels PX in which the pixel circuit elements is differently disposed. The display apparatus 10-2 may include the first pixel PXA and the second pixel PXB, and the disposition of pixel circuit elements in the first pixel PXA may be different from the disposition of pixel circuit elements in the second pixel PXB.

The first pixel PXA and the second pixel PXB may be disposed adjacent to each other in the first direction DR1 and may include a symmetrical area FA in which the pixel circuit elements are symmetrically disposed therein and an asymmetrical area NFA in which the pixel circuit elements are asymmetrically disposed therein, with respect to an imaginary line L1 located at the boundary between the first pixel PXA and the second pixel PXB.

The first pixel PXA and the second pixel PXB may share a data line DTL with each other. The data line DTL may be disposed at the boundary between the first pixel PXA and the second pixel PXB, may extend in the second direction DR2, and may be disposed along the imaginary line L1. In order for the first pixel PXA and the second pixel PXB to share the data line DTL with each other, the symmetrical area FA, which is a portion of the pixel circuit elements disposed in each of the first pixel PXA and the second pixel PXB, may have a symmetrical disposition structure with respect to the data line DTL. The asymmetrical area NFA, which is another portion of the pixel circuit elements disposed in each of the first pixel PXA and the second pixel PXB, may have an asymmetrical disposition structure with respect to the data line DTL.

A first capacitor electrode CE1' connected to a second node N2, which is a source node, may be disposed in the symmetrical area FA. The asymmetrical area NFA may be an area adjacent to the first capacitor electrode CE1'. A switching transistor T2 connected to a first node N1, which is a gate node, may be disposed in the asymmetrical area NFA. A capacitance Cp may be formed between the first capacitor electrode CE1'and a switching gate electrode GP2-1 of the switching transistor T2. Because the pixel circuit elements are asymmetrically disposed adjacent to the source node, the display apparatus 10-2 according to another embodiment may maintain the capacitance Cp constant even when an overlay deviation occurs.

The display apparatus 10-2 according to another embodiment may include first electrodes 110 and second electrodes 210 disposed in each of the first pixel PXA and the second pixel PXB. The first electrodes 110 may be symmetrically disposed with respect to the imaginary line L1 disposed at the boundary between the first pixel PXA and the second pixel PXB and extending in the second direction DR2 different from the first direction DR1. The second electrodes 210 may be asymmetrically disposed with respect to the imaginary line L1. For example, one of the first electrodes 110 of the display apparatus 10-2 according to another embodiment may have a symmetrical shape with respect to the second direction DR2.

For example, a first capacitor electrode CE1' included in the first electrodes 110 may have a symmetrical shape with respect to the second direction DR2. As described above, the first capacitor electrode CE1' may electrically connect a capacitor electrode of the holding capacitor Chold, a capacitor electrode of the storage capacitor Cst, and the driving transistor T1 to each other and may serve as the second node N3 of FIG. 3, which is the source node. The first capacitor electrode CE1' may have a symmetrical shape with respect to a line passing through the center of the first capacitor electrode CE1' and parallel to the second direction DR2. Accordingly, the first capacitor electrode CE1' may prevent or minimize an overlay deviation with electrodes of other layers disposed in the peripheral area.

As illustrated in FIG. 13, a bottom metal layer BML' may include a first lower scan signal line SL11, a reference voltage line RFL, a second scan signal line SL2, a lower capacitor electrode BML1', a first voltage line VDL, a second voltage line VSL, a first initialization voltage line VIL, and a second initialization voltage line VIL2. Among them, the lower capacitor electrode BML1' may be disposed below the first capacitor electrode CE1' and may have a structure that surrounds the first capacitor electrode CE1'. For example, the lower capacitor electrode BML1' may be larger than the outer side of the first capacitor electrode CE1' and may have a symmetrical rectangular shape, as illustrated in FIG. 13. The disclosure is not limited thereto, and the lower capacitor electrode BML1' may have a structure that surrounds the first capacitor electrode CE1' and any structure having a symmetrical shape with respect to a line passing through the center of the lower capacitor electrode BML1' and parallel to the second direction DR2.

As illustrated in FIG. 6, a first conductive layer GP may be disposed on the second insulating layer 104. In FIG. 12, the first conductive layer GP may include a first upper scan signal line SL12, a first gate electrode layer GP1, a second gate electrode layer GP2, a third gate electrode layer GP3, an operation control signal line ECL, an emission control signal line ECL2, and a third scan signal line SL3. The first conductive layer GP may also be referred to as a gate layer.

In the first capacitor electrode CE1' of the first conductive layer GP, the shape of the region adjacent to the fourth connection electrode BE4 may be different from the shape of the first capacitor electrode CE1 of FIG. 11. Similar to the lower capacitor electrode BML1', the shape of the first capacitor electrode CE1' is not limited to the illustrated shape (e.g., rectangular), and the first capacitor electrode CE1' may have any structure having a symmetrical shape with respect to the second direction DR2.

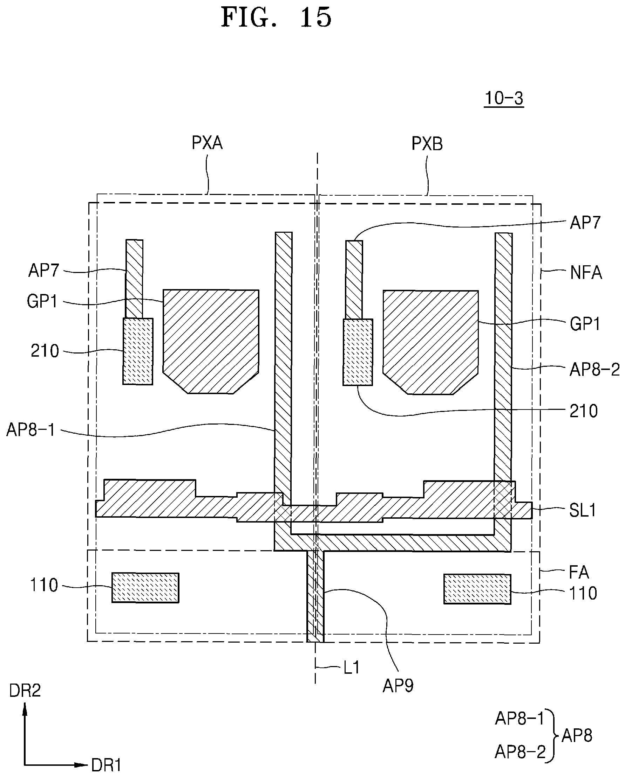

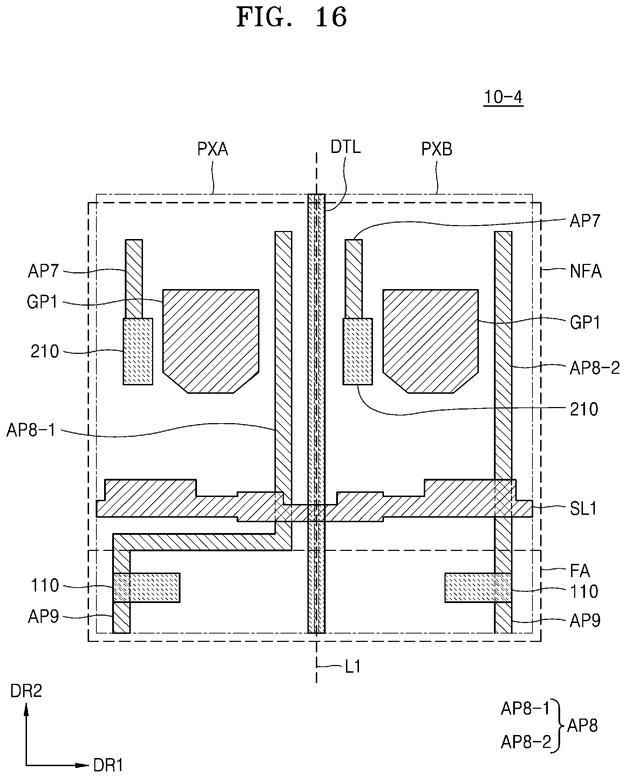

FIGS. 15 and 16 are schematic layout diagrams illustrating a portion of an area including a first pixel and a second pixel in a display area of a display apparatus according to another embodiment. For convenience, FIGS. 15 and 16 illustrate only a portion of a semiconductor layer AP, a portion of a first conductive layer GP, and a portion of a second conductive layer SP. In display apparatuses 10-3 and 10-4 of FIGS. 15 and 16, multiple thin-film transistors may be p-channel MOSFETs (PMOSs).

Referring to FIGS. 15 and 16, the display apparatuses 10-3 and 10-4 according to another embodiment may include multiple pixels PX. Each of multiple pixels PX may include at least one organic light-emitting diode and pixel circuit elements for driving the at least one organic light-emitting diode. Each of the pixels PX may include multiple thin-film transistors (see T1 to T6 of FIG. 3), a storage capacitor Cst, and a holding capacitor Chold as the pixel circuit elements. Each of the pixels PX may be electrically connected to a data line DTL, a scan signal line SL, an operation control signal line ECL, an emission control signal line ECL2, a first voltage line VDL, a second voltage line VSL, a reference voltage line RFL, and an initialization voltage line VIL.

The display apparatuses 10-3 and 10-4 may include multiple pixels PX in which the pixel circuit elements is differently disposed. The display apparatuses 10-3 and 10-4 may include a first pixel PXA and a second pixel PXB, and the disposition of pixel circuit elements in the first pixel PXA may be different from the disposition of pixel circuit elements in the second pixel PXB.

The first pixel PXA and the second pixel PXB may be disposed adjacent to each other in the first direction DR1 and may include a symmetrical area FA in which the pixel circuit elements are symmetrically disposed therein and an asymmetrical area NFA in which the pixel circuit elements are asymmetrically disposed therein, with respect to an imaginary line L1 located at the boundary between the first pixel PXA and the second pixel PXB.

The display apparatus 10-3 of FIG. 15 illustrates a case where the first pixel PXA and the second pixel PXB do not share a data line DTL with each other, for example, a case where the pixels respectively include individual data lines DTL corresponding thereto. The display apparatus 10-4 of FIG. 16 illustrates a case where the first pixel PXA and the second pixel PXB share a data line DTL with each other.

In case that multiple thin-film transistors are PMOSs, unlike NMOSs, pixel circuit elements disposed around a first gate electrode layer GP1, which is a gate node, may be asymmetrically disposed with respect to an imaginary line L1, and pixel circuit elements disposed in other areas may be symmetrically disposed. In case that multiple thin-film transistors are PMOSs, a capacitance may vary depending on an overlay deviation between a first gate electrode layer GP1 and a semiconductor layer AP disposed therearound. Accordingly, the display apparatuses 10-3 and 10-4 may asymmetrically dispose pixel circuit elements in an asymmetrical area NFA, which is a peripheral area of the first gate electrode layer GP1, and symmetrically dispose pixel circuit elements in a symmetrical area FA, which is another area.

As illustrated in FIG. 15, the semiconductor layer AP may include a seventh semiconductor pattern AP7, an eighth semiconductor pattern AP8, and a ninth semiconductor pattern AP9, which are spaced apart from each other. For convenience of explanation, only the seventh semiconductor pattern AP7, the eighth semiconductor pattern AP8, and the ninth semiconductor pattern AP9 are illustrated, but other semiconductor patterns may also be further included.

The seventh semiconductor pattern AP7 and the eighth semiconductor pattern AP8 may be asymmetrically disposed in the asymmetrical area NFA with respect to an imaginary line L1. The eighth semiconductor pattern AP8 may extend up to the symmetrical area FA across a first scan signal line SL1. For example, an eighth-1 semiconductor pattern AP8-1 extending from the first pixel PXA and an eighth-2 semiconductor pattern AP8-2 extending from the second pixel PXB may be electrically connected to a ninth semiconductor pattern AP9 in the symmetrical area FA.

The ninth semiconductor pattern AP9 may be disposed at a position overlapping the imaginary line L1 so as to be symmetrically disposed with respect to the imaginary line L1.

The second conductive layer SP may include first electrodes 110 and second electrodes 210. The first electrodes 110 may be respectively disposed in the first pixel PXA and the second pixel PXB and may be symmetrically disposed with respect to the imaginary line L1. The second electrodes 210 may be respectively disposed in the first pixel PXA and the second pixel PXB and may be asymmetrically disposed with respect to the imaginary line L1. For example, the first electrode 110 may be disposed in the symmetrical area FA and the second electrode 210 may be disposed in the asymmetrical area NFA. Only one first electrode 110 and only one second electrode 210 are illustrated for convenience of explanation, but it is obvious that other conductive patterns may also be included.

As illustrated in FIG. 16, the display apparatus 10-4 is a case where the first pixel PXA and the second pixel PXB share a data line DTL with each other. The data line DTL may be disposed at the boundary between the first pixel PXA and the second pixel PXB, may extend in the second direction DR2, and may be disposed along an imaginary line L1.

A seventh semiconductor pattern AP7 and an eighth semiconductor pattern AP8 may be asymmetrically disposed in the asymmetrical area NFA with respect to the imaginary line L1. The eighth semiconductor pattern AP8 may extend up to the symmetrical area FA across the first scan signal line SL1. For example, an eighth-1 semiconductor pattern AP8-1 extending from the first pixel PXA and an eighth-2 semiconductor pattern AP8-2 extending from the second pixel PXB may be electrically connected to a ninth semiconductor pattern AP9 in the symmetrical area FA.

For example, the ninth semiconductor pattern AP9 may be apart from the data line DTL. The first pixel PXA and the second pixel PXB may include the ninth semiconductor patterns AP9 respectively connected to the eighth-1 semiconductor pattern AP8-1 and the eighth-2 semiconductor pattern AP8-2. The ninth semiconductor pattern AP9 of the first pixel PXA and the ninth semiconductor pattern AP9 of the second pixel PXB may be disposed at positions symmetrical with respect to the imaginary line L1.

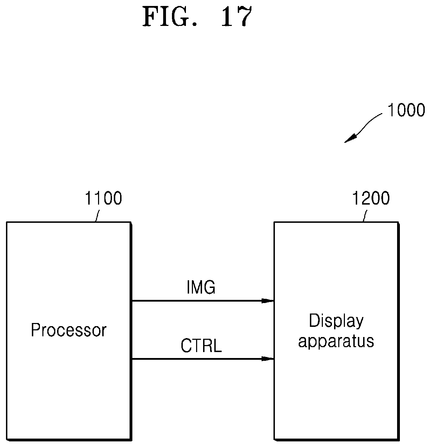

Referring to FIG. 17, the display system 1000 may include a processor 1100 and a display apparatus 1200.

The processor 1100 may perform various tasks and calculations. The processor 1100 may include an application processor, a graphics processor, a microprocessor, a central processing unit (CPU), and the like. The processor 1100 may be electrically connected to other components of the display system 1000 through a bus system to control the other components.

The processor 1100 may transmit image data IMG and a control signal CTRL to the display apparatus 1200. The display apparatus 1200 may display an image based on the image data IMG and the control signal CTRL. The display apparatus 1200 may be similarly configured to the display apparatus 10 described with reference to FIG. 1.

The display system 1000 may include a computing system providing an image display function, such as a smart watch, a mobile phone, a smart phone, a portable computer, a tablet personal computer (PC), a watch phone, an automotive display, smart glasses, a portable multimedia player (PMP), a navigation device, and an ultra mobile personal computer (UMPC). The display system 1000 may include at least one of a head mounted display (HMD) device, a virtual reality (VR) device, a mixed reality (MR) device, and an augmented reality (AR) device.

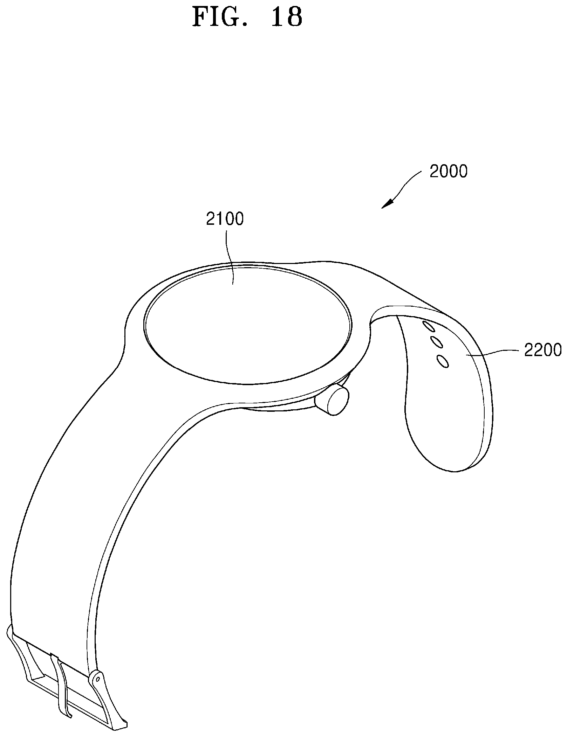

Referring to FIG. 18, the display system 1000 of FIG. 17 may be applied to a smart watch 2000 including a display unit 2100 and a strap unit 2200.

The smart watch 2000 may be a wearable electronic apparatus. For example, the smart watch 2000 may have a structure in which the strap unit 2200 is mounted on a user's wrist. Here, the display system 1000 and/or the display apparatus 1200 may be applied to the display unit 2100, and image data including time information may be provided to a user.

In the display apparatus according to the present embodiment, the pixel circuit elements may be asymmetrically disposed around the gate nodes of the first pixel PXA and the second pixel PXB with respect to the imaginary line, thereby preventing or minimizing a luminance deviation between the first pixel PXA and the second pixel PXB. Therefore, the display apparatus according to the present embodiment may display high-quality images.

Each of the embodiments described above may be implemented independently, but it is obvious that the structure of each of the embodiments may be applied in combination to other embodiments.

The disclosure has been described with reference to the embodiments illustrated in the drawings, but this is only an example. It will be understood by those of ordinary skill in the art that various modifications and equivalents may be made thereto. Accordingly, the true technical protection scope of the disclosure should be defined by the appended claims.

Specific executions described in the embodiments are one embodiment, which does not limit the scope of the embodiments in any way. In case that there is no specific mention such as "essential," "important," etc., it may not be a necessary component for the application of the disclosure.

The use of the term "the" and similar demonstratives in the specification of the embodiments (in particular, the claims) is to be construed to cover both the singular and the plural. In case that a range is described in the embodiments, it includes the invention to which individual values in the range are applied (unless otherwise indicated herein). This is the same as stating each individual value constituting the above range in the detailed description. Finally, operations constituting methods according to embodiments may be performed in any suitable order unless otherwise indicated herein or otherwise clearly contradicted by context. The embodiments are not necessarily limited by the order of description of operations. The use of any and all examples or example terms provided in the embodiments is simply intended to describe the embodiments in detail, and the scope of the embodiments is not limited by the examples or example terms unless otherwise claimed. In addition, it will be understood by those of ordinary skill in the art that various modifications, combinations and changes may be made according to design conditions and factors in the scope of the appended claims or equivalents thereof.

A display apparatus according to one or more embodiments includes a symmetrical region and an asymmetrical region of pixel circuit elements, thereby preventing or minimizing a luminance deviation between a first pixel and a second pixel. Therefore, the display apparatus according to the present embodiment may display high-quality images.

However, the effects of the disclosure are not limited to those described above and may be expanded in various ways without departing from the scope of the disclosure.

It should be understood that embodiments described herein should be considered in a descriptive sense only and not for purposes of limitation. Descriptions of features or aspects in each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A display apparatus (10, 10-2, 10-3, 10-4, 1200) comprising:
a first pixel (PXA) and a second pixel (PXB) disposed adjacent to each other in a first direction (DR1);a
first electrodes (110) disposed in each of the first pixel and the second pixel; and
second electrodes (210) disposed in each of the first pixel and the second pixel and apart from the first electrodes (110),
wherein the first electrode (110) of the first pixel (PXA) and the first electrode (110) of the second pixel (PXB) are symmetrically disposed to each other with respect to an imaginary line (L1) disposed at a boundary between the first pixel and the second pixel and extending in a second direction that is different from the first direction, and
the second electrode (210) the first pixel (PXA) and the second electrode (210) of the second pixel (PXB) are asymmetrically disposed to each other with respect to the imaginary line.

2. The display apparatus (10, 10-2, 10-3, 10-4, 1200) of claim 1, further comprising a data line (DTL) disposed at the boundary between the first pixel and the second pixel, extending in the second direction (DR2), and disposed along the imaginary line.

3. The display apparatus (10, 10-2, 10-3, 10-4, 1200) of claim 2, wherein the first electrodes (110), the second electrodes (210), and the data line (DTL) comprise a same conductive material.

4. The display apparatus (10, 10-2, 10-3, 10-4, 1200) of any of the preceding claims, wherein each of the first electrodes (110) of the first pixel (PXA) and of the second pixel (PXB) includes a first capacitor electrode (CE1).

5. The display apparatus (10, 10-2, 10-3, 10-4, 1200) of claim 4, wherein the first capacitor electrode (CE1) of the first electrode (110) of the first pixel (PXA) and the first capacitor electrode (CE1) of the first electrode (110) of the second pixel (PXB) are symmetrical to each other with respect to the second direction.

6. The display apparatus (10, 10-2, 10-3, 10-4, 1200) of claim 4 or 5, further comprising a first scan signal line (SL1) extending in the first direction, crossing the first pixel (PXA) and the second pixel (PXB), and electrically connected to the second electrodes (210),
wherein the second electrodes (210) is disposed between the first scan signal line (SL1) and the first capacitor electrode (CE1).

7. The display apparatus (10, 10-2, 10-3, 10-4, 1200) of claim 6, wherein the first scan signal line (SL1) comprises a first-1 scan signal line (SL1-1) and a first-2 scan signal line (SL1-2) parallel to the first-1 scan signal line (redundant with respect to claim 6).

8. The display apparatus (10, 10-2, 10-3, 10-4, 1200) of claim 6 or 7, further comprising a lower capacitor electrode (BML1) overlapping the first capacitor electrode (CE1),
wherein the lower capacitor electrode (BML1) and the first scan signal line (SL1) comprise a same material.

9. The display apparatus (10, 10-2, 10-3, 10-4, 1200) of claim 8, wherein the lower capacitor electrode (BML1) disposed in the first pixel (PXA) and the lower capacitor electrode (BML1) disposed in the second pixel (PXB) are symmetrically disposed with respect to the imaginary line (L1).

10. The display apparatus (10, 10-2, 10-3, 10-4, 1200) of claim 8, wherein each of the lower capacitor electrode (BML1) disposed in the first pixel (PXA) and the lower capacitor electrode (BML1) disposed in the second pixel (PXB) has a symmetrical structure with respect to the second direction.

11. The display apparatus (10, 10-2, 10-3, 10-4, 1200) of any of claims 4 to 10, further comprising an initialization voltage line (VIL) extending in the first direction and crossing the first pixel (PXA) and the second pixel (PXB),
wherein each of the first electrodes (110) includes fifth to eighth connection electrode (BE5 to BE8) and at least one of the fifth to eighth connection electrode (BE5 to BE8) are disposed between the first capacitor electrode (CE1) and the initialization voltage line (VIL).

12. The display apparatus (10, 10-2, 10-3, 10-4, 1200) of any of claim 4 to 11, further comprising a first capacitor (Cst) disposed in each of the first pixel and the second pixel,
wherein the first capacitor comprises the first capacitor electrode (CE1) and a second capacitor electrode (CE2) overlapping the first capacitor electrode.

13. The display apparatus (10, 10-2, 10-3, 10-4, 1200) of any of claims 4 to 12, further comprising a second capacitor (Chold) disposed in each of the first pixel and the second pixel,
wherein the second capacitor (Chold) comprises a third capacitor electrode (CE3) and a fourth capacitor electrode overlapping the third capacitor electrode, and
the fourth capacitor electrode is integrally formed with the first capacitor electrode.

14. An electronic apparatus comprising:
a display apparatus (1200) of any of the preceding claims; and
a processor (1100) configured to transmit image data (IMG) and a control signal (CTRL) to the display apparatus (1200).
